(19) Europäisches Patentamt
European Patent Office
Office européen des brevets

(11) Publication number: **0 246 452**
**A2**

(12) # EUROPEAN PATENT APPLICATION

(21) Application number: 87105679.2

(22) Date of filing: 16.04.87

(51) Int. Cl.³: G 06 F 15/60
G 08 G 1/09

(30) Priority: 24.04.86 US 855823

(43) Date of publication of application:
25.11.87 Bulletin 87/48

(84) Designated Contracting States:
AT BE CH DE ES FR GB GR IT LI LU NL SE

(71) Applicant: NORDA S.p.A.
Via Vallecanonica, 14/F
I-25127 Brescia(IT)

(72) Inventor: Duina, Gianfranco
1140 Pleasant Lane
Glenview Illinois 60025(US)

(74) Representative: Lecce, Giovanni
Dott. Giovanni Lecce & C. S.r.l. Via G. Negri 10
I-20123 Milano(IT)

(54) **Computerized trip planner and automotive navigator.**

(57) A driver of a vehicle is provided with a portable computer which receives a specified point of origin and desired point of destination, interprets an abstract representation of a road network stored in memory, and iteratively searches for and finds a permissible path from the point of origin to the point of destination having a substantially minimum travel time.

The memory for storages of the abstract representation includes a main memory bank of read-only memory storing information about the main roads in a certain territory, and first and second interchangeable data cartridges storing information about the main and minor roads in limited areas in the territory including the point of origin and the point of destination, respectively. The search procedure finds a number of possible paths and their total travel time for comparison, and each possible path is found by selecting the next best pair of main roads leading out of the town including the point of origin and into the town including the point of destination, selecting the best roads connecting the respective points to the respective main roads, and selecting the best roads connecting the out-of-town portions of the main roads.

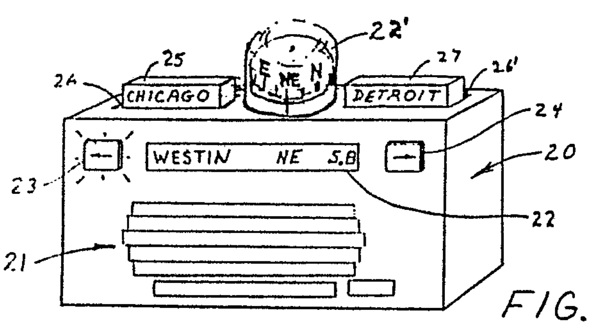

FIG. 1

EP 0 246 452 A2

0246452

# COMPUTERIZED TRIP PLANNER AND AUTOMOTIVE NAVIGATOR

## BACKGROUND OF THE INVENTION

### 1. Field of the Invention

The present invention relates to a routing computer of the kind which receives instructions by the operator of a vehicle who desires to travel from a given point of origin to a given point of destination, and which selects a route between the origin and destination and indicates to the operator the sequence of roads included in the selected route.

### 2. Description of the Related Art

The conventional method of automotive navigation is by driving along a route selected by viewing a paper road map. Preferably the best route is selected in advance and indicated on the map, for example, by tracing or highlighting over the sequence of roads included in the route. Also, as is the custom in a "road rally", automotive navigation is facilitated by having a person in the vehicle other than the driver who can orient and read the road map and give specific instructions to the driver during the trip.

A number of devices have been proposed as improvements or substitutes for conventional road maps. Fitzgerald U.S. Patent 4,312,577, for example, discloses a map display system in which a selected portion of a map on a moveable slide is magnified and projected onto a screen. As further disclosed in U.S. Patents 4,490,717; 4,513,377; 4,531,123; 4,532,514; 4,543,572 and 4,550,317, a dead reckoning system or other means for detecting the position of a vehicle with respect to the earth may be used to show the position of the vehicle on the display of the map or to orient the display of the map with respect to the vehicle's heading. Such devices, however, have been relatively expensive and, therefore, have not become widely used.

A somewhat different kind of device for aiding the driver provides information in the form of messages about a specified location or route. In Kashio U.S. Patent 3,925,641, for example, data corresponding to the route to be taken are stored in a memory device. During a trip, the vehicle's distance of travel is sensed to determine the vehicle's position along the route. In response to the vehicle's position along the route, messages are generated to instruct the driver to turn right or turn left, or to advance until an indicated distance to the end of the route is reduced to zero.

In Turco U.S. Patent 4,301,506, a memory in a routing computer is arranged in the form of a matrix storing a unique predetermined route for each combination of origin and destination. The driver supplies a known city of origin and a desired city of destination so that the unique corresponding route is recalled from memory. The routing computer is said to provide a visual indication of the subroutes to be taken while the vehicle traverses the journey, and to be capable of indicating alternate routes in the event of a traffic tie-up and capable of being reprogrammed to reflect a change in the geographical area within which the vehicle is traveling.

Holland U.S. Patent 4,481,584 discloses a microcomputer for displaying highway information contained in plug-in data cartridges. The driver uses a keyboard to input the selection of highway from which roadway information is desired. The desired information is read from a plug-in data cartridge and visually or audibly transmitted to the driver.

SUMMARY OF THE INVENTION

The inventor has recognized that the above-described related art does not address the basic needs of the average driver. With today's road systems, in populated areas, a driver does not need to be told exactly where he is at all times because roads are marked at most intersections. Therefore, the additional expense of a vehicle location system is not justified for the average driver. Every driver, however, is occasionally faced with unfamiliar territory. Although the driver could consult a map, the steps of finding one's location on the map, orienting the map, plotting the best route on the map, and following that route are laborious and subject to error.

Accordingly, the primary object of the invention is to provide an economical automotive navigation computer which determines the best route to take given a vehicle's point of origin and the desired point of destination expressed in terms of street addresses or intersections.

Another object of the invention is to provide an automotive navigational computer with a data organization capable of storing an abstract representation of a road network in a reduced memory space.

Still another object of the invention is to provide an automotive navigational computer storing an abstract representation of major roads for a large territory in a main memory bank and receiving at least two interchangeable data cartridges each storing an abstract representation of major and minor roads for a more limited area, so as to provide a versatile data base for intercity routing.

According to the present invention, these objects are achieved in a method of eliminating the use of maps by the operator of a motor vehicle who wishes to travel over roads within a certain territory from a given point of origin to a desired point of destination along a route having a minimum travel time, comprises the following steps:

a) providing a data processor completely contained within said motor vehicle, said data processor having a central processing unit and a memory containing a set of instructions which are executed by said central processing unit, said memory also storing an abstract representation of the network of said roads within said territory,

said data processor further including a manually-operated input means for receiving from said operator said given point of origin and said desired point of destination,

said set of instructions including a procedure executed by said central processing unit for interpreting said abstract representation of said network of roads to iteratively search for and find a first path of said roads connecting said given point of origin and said desired point of destination received by said input means, compute the travel time along said first path, search for and find a second path of said roads connecting said given point of origin and said desired point of destination received by said input means, compute the travel time along said second path, select the path having the smaller travel time, and iterate said searching, finding, computing and selecting to determine a path having substantially the minimum travel time between said given point of origin san said desired point of destination, and

said data processor further including output means for providing said operator with information for guiding said motor vehicle along said path having substantially the minimum travel time,

b) manually operating said input means to receive said given point of origin and said desired point of destination, and

c) guiding said motor vehicle in response to the information provided by said output means to thereby guide said motor vehicle along said path having substantially the minimum travel time between said given point of origin and said desired point of destination.

The present invention provides, moreover, an automotive navigator for use in a motor vehicle to eliminate the use of maps by the operator of the motor vehicle, said automotive navigator comprising, in combination,

a data processor having a central processing unit and a memory containing a set of instructions which are executed by said central processing unit, said memory also storing an abstract representation of the roads within a certain territory, said abstract representation including a list of segments of said roads and respective properties and conditions for said road segments, and a list of intersections of pairs of said roads which have restrictions on the flow of traffic from one road to the other,

a manually-operated input means for receiving from said operator information defining a specified point of origin and a desired point of destination, and

an output means for providing said operator with directions on how to drive along a selected path of said roads,

wherein said set of instructions executed by said central processing unit includes a procedure for obtaining said information received by said input means, interpreting said abstract representation of said roads to select a path from said point of origin to said point of destination consistent with said conditions and restrictions and having a substantially minimum travel time, and generating and transmitting to said operator via said output means directions on how to drive along the selected path having a substantially minimum travel time, wherein said procedure searches for and finds said path having a substantially minimum travel time by iteratively selecting roads, combining roads to form paths from the point of origin to the point of destination, computing the travel time along said paths, and comparing the travel times to select the path having a minimum travel time.

The features, objects and advantages of the invention will become apparent from the following detailed description in connection with the accompanying drawings which illustrate preferred, examplified but not limitative embodiments of the present invention, and in which:

FIG. 1 is a perspective view of a computerized trip planner and automotive navigator according to the present invention;

FIG. 2 is a schematic block diagram showing the internal components of the computerized trip planner of FIG. 1 and also showing various optional devices and interconnections to the basic components;

FIG. 3 is a diagrammatic representation of the data banks used in the trip planner of FIG. 1 for storing an abstract representation of a road network;

FIG. 4 is a diagram of the data files used for organizing the data stored in the data banks;

FIG. 5 is a diagram showing the contents of a road file record;

FIG. 6 shows a road network as represented on a conventional graph;

FIG. 7 is a pictorial representation of an abstract representation of the map in FIG. 6;

FIG. 8 is a further abstract representation of the map shown in FIG. 6;

FIG. 9 shows the contents of a town file record;

FIG. 10 shows the contents of an A-knot file record;

FIG. 11 shows a simplified map which is abstractly represented in the data banks of FIG. 3;

FIG. 12 is a simplified flowchart showing the procedure executed by the computerized trip planner of FIG. 1 for finding a route from a given point of origin to a desired point of destination; and

FIGS. 13-19 show a flowchart for the preferred procedure executed by the computerized trip planner of FIG. 1.

While the invention will be described in connection with certain preferred embodiments illustrated in the accompanying drawings, it will be understood that it is not intended to limit the invention to the particular embodiments shown. On the contrary, the intention is to cover all alternatives, modifications and equivalents as may be included within the spirit and scope of the invention as defined by the appended claims.

## DESCRIPTION OF THE PREFERRED EMBODIMENTS

Turning now to FIG. 1, there is shown an automotive navigator generally designated 20 which uses a computerized trip planner according to the present invention. The automotive navigator 20 incorporates a conventional microcomputer having a processing unit which executes a sequence of instructions stored in a memory. In addition to this sequence of instructions, the memory includes data banks which store an abstract representation of a network of roads.

Typically, a driver uses a road map to find the answers to a number of questions related to a planned trip. It is presumed that the driver knows his or her point of origin, and has at least one desired point of destination in mind. Typically, the driver references one or more road maps to determine the "best" route interconnecting the point of origin and point of destination, the time required to traverse that route and the length of the route. It is presumed that the "best" route is the route having the minimum travel time from the point of origin to the point of destination. A road map does not directly answer any of these questions, but the driver may refer to the map to obtain the necessary information to answer these questions.

A conventional road map is a kind of scale model of a part of the earth's surface, transposed on a flat surface. In this regard, the map stores data about a road network using the same organization as is found in nature. This organization, however, is not convenient for interpretation by a computer such as the microcomputer in the automotive navigator 20 shown in FIG. 1.

According to an important aspect of the present invention, the memory of the microcomputer stores an abstract representation of a road network in such a form that it may be stored in a reasonably sized memory and may easily be retrieved and interpreted to answer the typical questions posed by the driver.

In order to receive the driver's point of origin and desired point of destination, the automotive navigator includes an alphanumeric keyboard generally designated 21. For acknowledging receipt of such data and for indicating answers to various questions, the automotive navigator 20 also includes an alphanumeric display 22. Once the current point of origin and desired destination have been received, the automotive navigator 20 generates a series of instructions indicating the roads to follow. Preferably, at any given point in the journey, the alphanumeric display 22 displays at least the current heading and required mileage in order to reach the next street which is also indicated. Depending on the size of the display 22, the display could also indicate the current street, and the approximate required time to reach the next street. The automotive navigator also includes means for displaying whether a left or right turn is required to reach the next street. For this purpose, the automotive navigator 20 in FIG. 1 includes push-button switches 23 and 24 which have respective left and right arrow markings which can be selectively indicated or backlit by respective lamps. As shown in FIG. 1, for example, the instruction to the driver is to continue in a north-easterly direction for 5.8 miles until the street named "Westin" is reached, where upon the driver should make a left turn. After making this left turn, the driver activates the illuminated left turn push-button 23 so that the automotive navigator 20 may present the next instruction. For indicating the direction of travel of the vehicle, the automotive navigator includes a magnetic compass 22'.

According to an important aspect of the present invention, the data bank in memory includes a permanent storage for a large territory such as interstate main roads, and accepts at least two interchangeable memory cartridges including the main roads and minor roads for selected areas.

For intercity trips, for example, a data cartridge 25 including the point of origin is inserted into a slot 26 in the automotive navigator 20, and a data cartridge 27 including the point of destination is inserted into a second slot 26'. In this fashion, the contents of the data banks can be augmented or changed to suit the needs of a particular driver, and a large amount of information can be made available at a relatively low cost. It is expected that the driver would own a few cartridges for the areas in which he frequents and could occasionally rent or borrow cartridges for other areas. Moreover, the automotive navigator 20 could be provided with a programmable memory for receiving data from a cartridge. In this way, service stations could permit their customers to borrow data cartridges for the relatively limited time required to transfer data from the cartridge to the programmable memory.

Turning now to FIG. 2, there is shown a block diagram illustrating the internal components of the automotive navigator, and which also illustrates connections to a number of optional components and accessories. The keyboard 21, alphanumeric display 22, selectively illuminated pushbutton switches 23, 24, and the data cartridges 25, 27 are connected to a central processing unit 28. The central processing unit 28 executes instructions stored in read-only memory (ROM) 29 and also addresses a random access memory (RAM) 30 for temporary storage of intermediate results. The ROM 29 includes the permanent storage of the abstract representation of the large territory referred to above.

The automotive navigator 20 shown in FIG. 1 is intended for the average consumer, and therefore is provided with a very economical display means 22, 23 and 24. As should be apparent to a person of ordinary skill in the art referring to the related patents cited above, more elaborate display means could be provided at additional cost. The alphanumeric display 22, for example, could display a number of lines of characters, and could scroll up and down to display supplemental information including messages that exceed the number of characters that could be displayed at any given time.

As shown in FIG. 2, an optional graphic display 31 such as a liquid crystal dot matrix display or cathode ray tube display could be used for showing a graphic reconstruction of the relevant portion of the road network, and the road segment currently being considered could be indicated on that display by highlighting or flashing the road segment. The automotive navigator could be provided with an optional printer 32 for printing on paper the entire set of instructions to the driver for traveling over a desired route. Moreover, an optional voice synthesizer 33 could be added to provide spoken messages to the driver.

As should be apparent to a person of ordinary skill in the art referring to the related patents cited above, the automotive navigator could receive data from optional external sources which could be used in addition to the prestored information about the road network or which could be used to temporarily update the prestored information. A magnetic or gyroscopic compass 34 could be used to provide the current heading of the vehicle and to orient a displayed portion of the road network with respect to the heading of the vehicle. A wheel rotation sensor 35 responsive to the motion of the vehicle could be used to enable the central processing unit 28 to compute and display the remaining distance or time along each road segment. A mobile radio receiver 36 could be used to detect signals broadcasted by local radio stations regarding traffic congestion or roads that are temporarily closed. This radio receiver 36 could also be used to receive data from a central data bank regarding the roads in a local area and also could be used to receive information about local weather conditions or available lodging facilities.

In addition to the abstract representation of the road network, the data in the ROM 29 could include information about specific points of interest along the route. Moreover, a programmable nonvolatile memory such as EEPROM 37 could be provided for receiving the driver's home address. Then the driver's home address could easily be selected as either a starting or destination point.

In addition to a point of origin and point of destination for a trip, the driver may enter instructions from the keyboard 21 to update the current vehicle position in the event that the vehicle temporarily departs from the best path between the origin and destination that has been selected by the central processing unit 28. Then the current position is used as a new point of origin along with the previously entered point of destination, and a new best path is computed. Moreover, the user could program a portion of the nonvolatile memory 37 with the names of roads and respective conditions which are either used in addition to the roads and conditions already prestored in memory, or which are used in lieu of the prestored conditions and therefore temporarily change or update the prestored road conditions.

A number of vehicles currently being manufactured have engine control and vehicle maintenance computers. As shown in FIG. 2, the central processing unit 28 of the automotive navigator 20 could be linked to an engine control and vehicle maintenance computer 38. The maintentance computer 38 has sensors for sensing engine and vehicle conditions. These sensors include, for example, an air inlet temperature sensor 39, a tachometer 40, a fuel gauge 41, an exhaust oxygen sensor 42, and an engine vacuum sensor 43. In response to these sensors, the maintentance computer 38 operates engine controls 44 and determines the status of the vehicle. The central processing unit 28 is linked to the maintenance computer 38 in order to obtain the vehicle status information and display the information to the driver. Therefore, the driver may be kept informed of the need to replenish the fuel supply, the current and average rate of fuel consumption, impending engine problems, and maintenance and service intervals.

Turning now to FIG. 3, there is shown a diagram of the various data banks generally designated 50 included in the memory of the automotive navigator 20 of FIG. 1. The data banks include a main bank 51 (in ROM 29 of FIG. 2) which stores, for example, an abstract representation of the interstate roads in the continental United States. The data in the main bank 51 is augmented by data in the first cartridge 25 and the second cartridge 27, if these cartridges are plugged into the automotive navigator 20. The geographic area corresponding to the first cartridge 25 is designated as area #1, and the geographic area corresponding to the data in the second cartridge 27 is designated as area #2. It should be noted that for finding routes along the main interstate roads, the cartridges 25 and 27 are not needed so long as the point of origin and point of destination occur on the main interstate roads represented by the data stored in the main bank 51. This will become clear from the following detailed description of the interpretation of the data stored in the data banks 50.

The data banks 50 also include data stored in the programmable nonvolatile memory (EEPROM) 37. These data include the previously mentioned home address and information entered by the driver to update or override the data stored in the main bank 51 or the data cartridges 25 or 27. In this regard, the central processing unit (28 in FIG. 2) first searches the updated data in the EEPROM 37, and uses data found therein in lieu of data which might be stored in the main bank 51 or the cartridges 25 or 27. If the desired data are not found in the EEPROM 37, then the main bank 51 and the cartridges 25 and 26 are searched.

The data banks 50 of FIG. 3 are organized in terms of three main groups of data files. The data files, generally designated 55, are shown in FIG. 4. These data files include road files 56, town files 57, and A-knot files 58. Each of the data banks 25, 27, 37 and 51 may have a road file 56, a town file 57, and an A-knot file 58. These files include information about the network of roads in the above-mentioned geographic areas but need not store the information about other natural or artificial aspects of the earth's surface, such as rivers, lakes, seas, mountains, railroads, or buildings. The road files 56 store information about the road segments in the geographic area. In each road file, the information about the road segments is grouped in terms of the towns including the road segments. Each of the data cartridges 25, 27 has a town file in which all of the towns of their respective geographic areas #1 or #2 are recorded. The main bank 51 need not include a town file.

The data cartridges 25 and 27 as well as the main bank 51 store A-knot files 58 containing data about anomalous connections or intersections between certain roads. As will be described further below, traffic may flow in any one of eight different ways at an intersection between two roads, and if any of these ways is restricted, for example by a no left turn condition, that restriction is recorded in the A-knot files 58. The word "knot" designates the point where two or more roads cross or join each other.

Turning now to FIG. 5, there is shown the organization of a typical record in the road files. A single record is provided for each road segment or link between the intersections or knots. For the purpose of abstract representation in memory, a road may be represented as a number of records for any number of reasons. If only a certain stretch of a road has a one-way condition, that stretch is recorded in a separate record. If different stretches of the same roads can be traveled at cruise speeds that are substantially different, and if such stretches are long enough to be worthy of independent consideration, then they are recorded in separate records. The stretches of road are also recorded separately if there is an interruption between the two stretches of the same road. This may occur, for example, because isolated road segments have been given the same name, or because a portion of a road may be temporarily blocked, for example, for maintenance or repair. Information about a road is also recorded in separate records if there are adjacent segments of the road which are parts of the same road, but which are not substantially in line.

As shown in FIGS. 6-8, the internal representation of the road network may substantially depart from the representation as in a conventional map so that the abstract representation in memory requires a reduced memory space and is more easily searched and interpreted by the automotive navigator.

As shown in FIG. 6, a section 61 of a conventional map shows the roads as they appear on the earth's surface, including curves 62 or twists 63 in the roads. As shown in FIG. 7, the curve 62 shown in FIG. 6 can be represented as a straight road segment or link 62' having an apparent "length" that is greater than the distance between the knots 66 and 67 defining the end points of the road segment or link 62'. Similarly, the twisted portions 63 of the road shown in FIG. 6 is represented as a straight road segment or link 63' shown in FIG. 7 and extending between the knot 67 and a knot 68. Therefore, in the abstract representation shown in FIG. 7, in each road file record, there is represented an uninterrupted road or stretch of it, with the same cruise speed and the same one-way condition (if any) along all of it.

In many instances, the abstract representation shown in FIG. 7 can be further abstracted and represented as shown in FIG. 8. In this case, the section 61 of the map in FIG. 6 is represented as a section 70 in which the intersection or knot 67 has been moved in order to further reduce the memory requirements for storing the abstract representation of the road network. The representation of FIG. 7, for example, requires a road file record for each of the road segments or links 62', 63', 71, and 73 which share the common intersection or knot 67. By using the representation of FIG. 8, the knot 67 is represented by a knot 67' occupying a different position so that the road segments 62' and 73 in FIG. 7 can be represented as colinear segments 62", 73', and so that the segments 63' and 71 can be represented as colinear segments 63" and 71'. If colinear and adjacent road segments have the same one-way condition and similar cruise speeds, then they can be represented in a single road file record as a single road segment or link. Therefore, the segments 62" and 73' can be represented in a single road file record, and the segments 63" and 71 can be represented in a single road file record. Therefore, the representation shown in FIG. 8 requires two fewer road file records than the representation shown in FIG. 7.

Returning to FIG. 5, for each road file record there is an entry specifying an associated road name and the type of road. The road type is specified by a single letter or byte including, for example, the letter H designating a divided highway, the letter R designating a road, a letter D designating a drive, the letter A designating an avenue, the letter B designating a boulevard, the letter L designating a lane, and the letter S designating a square. To save memory space, the road segments having the same road name are stored sequentially in the road files, and the road name and type are supplied for only the first record, and the successive records have a road name and type entry having only an asterisk designating that the road name and type for the successive record is the same as the road name and type entry of the previous record.

Each road file record also includes an entry storing the "cruise speed" or estimated average speed possible on that road or road stretch, an entry designating any one-way condition, an entry indicating the "distance class" of the road segment, an entry specifying the coordinates of the beginning point (M) of the road segment, an entry indicating the coordinates of the ending point (N) of the road segment, and an entry indicating the length of the road segment. The "distance class" is either "S" indicating a square, "R" indicating that the coordinates of the ending point (N) are specified by relative coordinates with respect to the beginning point (M), or "A" indicating that the coordinates of the ending point (N) are specified by absolute coordinates in longitude and latitude. As introduced above, the length of the road segment may be larger than the distance of the road segment since the road segment may represent a curved or twisted piece of road.

The coordinates are represented with respect to a cartesian coordinate system in which the X-axis represents the 60° south parallel and the Y-axis represents the 180° meridian with respect to the earth. The coordinates are internally represented by fixed point binary numbers and the least significant bit or resolution corresponds to a measuring unit length of 2.5 meters. This resolution is equivalent to a good quality 1:10,000 road map. The driver or operator, however, is not aware of this reference system being used for internal representation, since all of the instructions received and messages transmitted by the automotive navigator are given in kilometers or miles from one place to another.

For representing most lengths or coordinates, three bytes are used, each byte including eight bits, which permits the representation of a fixed point value from 0 to 16,777,215. This is sufficient to represent the maximum coordinates or distances, which occur along the X-axis representing the equator's circumference of about 16,000,000 measuring units. In short, a point on the earth is located by a positive longitudinal deviation from the 180° meridian and by its positive latitude deviation from the south parallel, both of which are expressed in measuring units of 2.5 meters.

For reducing the storage requirements when both the difference in longitude and the difference in latitude between the beginning point M and ending point N are smaller than 32,768 measuring units, the distance class is "R" and the longitude and latitude of the ending point N are represented as a two byte number designating the relative coordinates in longitude and latitude of the ending point N with respect to the coordinates in longitude and latitude of the beginning point M. The 65,536 combinations available in each two byte number are used to represent the range -32768 to +32768 by excluding the zero point. In other words, if the two byte number is zero or negative, its value is decreased by one unit during conversion to a three byte number for use in calculations. Moreover, if the road file record has a type "S" designating that it is a square, then the road file record does not include an entry for the ending point N. Therefore, the memory requirements for storing the abstract representation of the road network are further reduced.

Preferably the average cruise speed, the class of distance of the road, and any one-way condition, are encoded in one byte. The 256 possible values are divided in 7 ranges, as illustrated in Table I below:

TABLE I. ENCODING OF CRUISE SPEED, CLASS OF DISTANCE AND ONE WAY CONDITIONS

| Value's range | Speed (Km/h) | Class of Distance | One-Way Direction |
|---|---|---|---|
| 0-41 | value*3+40 | R | two-way road |
| 42-83 | (value-42)*3+40 | A | two-way road |
| 84-125 | (value-84)*3+40 | R | 0 to 3.1415 rad |
| 126-167 | (value-126)*3+40 | A | 0 to 3.1415 rad |
| 168-209 | (value-168)*3+40 | R | 3.1416 to 6.2830 rad |
| 210-251 | (value-210)*3+40 | A | 3.1416 to 6.2830 rad |
| 252-255 | ----- | square | ------ |

The information regarding the class of distance allows a correct reading of the coordinates of the ending point N (3+3 bytes, 2+2 bytes, or no bytes in the case of a square). As shown in the example, the information about the one-way condition indicates one of the two possible directions of the road a vehicle is permitted to travel.

Shown below in Table II are the records for a certain road:

TABLE II. SAMPLE ROAD RECORDS

| | | | | | | |
|---|---|---|---|---|---|---|
| ohios | 109 | 2,000,000 | 3,000,000 | 1,000 | 0 | 1,200 |
| * | 25 | 2,001,000 | 3,000,000 | 1,100 | 0 | 1,100 |
| * | 25 | 2,002,260 | 3,000,000 | 2,000 | 0 | 2,000 |
| mainea | ... | | | | | |

The road records in Table II above indicate that there are three stretches of a road named Ohio Street.

The first stretch can be driven at (109-84)*3+40 = 115 km/h. The first stretch is class R, is one-way, and has a direction of travel in the range 0 to 3.1415 rad.

The first stretch begins at 2,000,000*2.5/1,000 = 5,000 km east of the 180 degree meridian and 3,000,000*2.5/1,000 = 7,500 km north of the 60 degree south parallel.

The first stretch ends 1,000*2.5/1,000=2.5 km north of the starting point.

The first stretch is 1,200*2.5/1,000=3 km long, and therefore it is twisting.

The first stretch is followed by a class R second stretch ending 1,100*2.5/1,000 = 2.75 km north. The second stretch has the cruise speed of 25*3+40=115 km/h, and it is a two-way, straight road.

The third stretch is a class R stretch, beginning at 10,002,260 measuring units north instead of at the ending point of the second stretch which is at 10,001,000+1,100 = 10,002,100 measuring units north. Therefore, there is an interruption in Ohio Street, which explains why the third stretch, in-line with the second, two-way road, having the same cruise speed, is recorded separately.

Finally, the end of the records for Ohio Street is indicated by the first record of Maine Avenue.

Turning now to FIG. 9, there is shown the organization of a town file record generally designated 80. The town files store the names of the towns included in their corresponding geographic areas. Each record 80 includes the name of one of these towns, the progressive number or pointer to its first road in the corresponding roads file, and the progressive number or pointer to its first A-knot in the corresponding A-knot file. Therefore, the pointer to the first road and A-knot for a given town can be used together with the pointer to the first road and A-knot from the immediately following town file record to locate the group of road file records and A-knot file records associated with the given town. If the same data cartridge covers more than one state, it is possible to have two different towns with the same name. To avoid confusion in this case, an abbreviation of the respective state is appended to the name of the town entered in the town file record.

Turning now to FIG. 10, there is shown the organization of an A-knot file record generally designated 90. To indicate the road intersection pertaining to the A-knot record 90, the record includes respective pointers to the first road and the second road at the intersection. Following the convention previously used for one-way conditions, each of the roads has one of two possible directions of travel, including a direction "A" having an angle between zero and 3.1415 radians, and a direction "B" having an angle between 3.1416 and 6.2830 radians. Therefore, associated with the intersection there are eight possible ways of traveling between the first road and the second road, as identified in Table III below:

TABLE III. CONVENTIONS FOR POSSIBLE WAYS OF TRAVEL AT AN INTERSECTION

| Number | From | Direction | To | Direction |
|---|---|---|---|---|
| 1 | Road X | A | Road Y | A |
| 2 | Road X | A | Road Y | B |
| 3 | Road X | B | Road Y | A |
| 4 | Road X | B | Road Y | B |
| 5 | Road Y | A | Road X | A |
| 6 | Road Y | A | Road X | B |
| 7 | Road Y | B | Road X | A |
| 8 | Road Y | B | Road X | B |

If at least one of these eight possible ways of travel are not available or allowed but which are not specified by the one-way conditions for the roads X and Y, then the intersection is an anomalous knot or A-knot. The corresponding A-knot file record includes the progressive numbers or pointers to the two crossing streets, and one byte, having bits in positions numbered from 1 to 8 which are logical 1's or 0's accordingly to the availability of the connection having the same progressive number.

An example of an A-knot file record is shown below.

TABLE IV. SAMPLE A-KNOT FILE RECORD

(Pointer to N-S Road X)
(Pointer to E-W Road Y)
$10,000,010_2$

The binary value "1" is chosen to indicate a prohibited way of travel, and the position of bit one is chosen to be the least significant bit. Therefore, for the sample record in Table IV above, travel is prohibited from direction A of road X to direction B of road Y, and from direction B of Road Y to direction B of road X. Direction A of road X is north and direction B of road X is south. Direction A of road Y is east and direction B of road Y is west. Therefore, a north-bound traveler on road X cannot turn left, and a west-bound traveler on road Y cannot turn left.

To summarize the previous description, the automotive navigator 20 of FIG. 1 has prestored in memory lists of roads, with names and types, coordinates of the end points, one-way conditions, cruise speeds, and lengths. The memory of the automotive navigator also stores lists of towns, indicating where in memory the corresponding roads and A-knots are found, and the memory also includes lists of A-knots, which define restrictions at road intersections apart from one-way conditions. The above-mentioned data are stored in three different areas of memory. The list of towns, the list of roads, and the list of A-knots, relative to the area of the starting point of the planned trips, are recorded in the data cartridge 25 that has been inserted in the first slot 26 of the navigator 20. The equivalent lists for the ending point are recorded in the second data cartridge 27 inserted in the second slot 26'. In case the second cartridge 27 is not inserted in the slot 26', then the navigator 20 expects to find the ending point in the first cartridge 25 in the first slot 26. In other words, in this case both the specified point of origin and the desired point of destination are in the same area. The automotive navigator 20 also includes the list of highways of the whole territory and the list of their A-knots which are recorded in the main bank memory 51 of FIG. 3.

A number of different procedures can be executed by the central processing unit (28) to interpret the prestored data to generate a sequence of instructions for the driver, in accordance with the present invention. Basically, the procedure should use an iterative process, trying at each iteration a new path, and comparing the new path with the up-to-then best path. The iteration should be stopped either after a pre-set number of times (for example, proportional to the distance between the point of origin A and the point of destination Z), or when the time calculated for the up-to-then best path is close enough to a certain time proportional to the distance between the point of origin A and the point of destination Z.

Turning now to FIGS. 11 and 12, there is shown in FIG. 11 a map generally designated 100 which is used by the preferred procedure shown in the flowchart generally designated 110 to find a path from the specified point of origin A in area #1 having substantially the minimum travel time to a desired point of origin Z in second area #2. In the first step 111 shown in FIG. 12, the road intersection of the specified point of origin A is entered, for example, by entering the pair of street names at the road intersection. Similarly, in step 112, the road intersection of the desired point of destination Z is entered by entering the names of the two roads at that intersection. Next, in step 113, the reference line between the point of origin and point of destination is determined, and a time limit is computed proportional to the distance between the point of origin and the point of destination.

In the first step 114 of the iteration loop, the next best main road MA in the area of the point of origin is selected. In the first iteration, for example, this main road is selected as the road leading out of area #1 which is closest to the reference line. During successive iterations, the next best main road is selected as the road which is the next closest road to the reference line. Similarly, in step 115, the next best main road MB in the area of the point of destination is selected. Next, in step 116, a good path is found from the point of origin to the first main road MA. This path, for example, is designated MA.1 in FIG. 11. Similarly, in step 117, a good path from the point of destination Z to the second main road MZ is found. As shown in FIG. 11, this path includes the road segments MZ.1 and MZ.2. To complete the path from the point of origin A to the point of destination Z, in step 118 a good path is found connecting the first main road MA and the second main road MZ. As shown

in FIG. 11, this connecting path extends from the intermediate point PA on the main road MA to the intermediate point PZ on the second main road MZ.

In step 119, the total travel time of the current route completed in step 118 is compared to the total travel time along the best prior route in order to select the better of the best prior route and the current route. Then, in step 120, the number of iterations is compared to a predetermined maximum number N and the travel time of the best route is compared to the time limit computed in step 113. If the number of iterations is less than the predetermined maximum N or if the iteration time is less than a predetermined time limit, then execution jumps to step 114 to continue the iterative process. Otherwise, in the final step 121, the best route is shown from the point of origin to the point of destination, using the display 22 as shown in FIG. 1 and as described above.

Although there are a number of ways of programming the basic control procedure shown in FIG. 12, a flowchart of the preferred procedure is shown in FIGS. 13-19. Turning to FIG. 13, the preferred procedure starts in step 131 when power is turned on, or in step 132 in response to a reset command entered from the keyboard (21 in FIG. 1). Next in step 133 the automotive navigator displays the message "FROM:" so that the town of the point of origin is received from the user in step 134. Step 134 is a subroutine "T" shown in FIG. 14.

Turning for the moment to FIG. 14, the town of the point of origin is received in step 135. In step 136, a null response is checked. If a null response is received from the operator, then in step 137 a flag is tested to determine whether the subroutine "T" was called in step 134 of FIG. 13. If so, the operator is told in step 138 to "try again" and in step 139 the keyboard is scanned for another entry.

If in step 137 the subroutine "T" was not called from step 134, then it is being called to determine the value of the town including the point of destination, and in step 140 the town including the point of destination is presumed to be the same as the town including the point of origin.

If in step 136 it is found that the name of a town has been entered, then in step 141 the town files are searched to determine whether the town can be found in the files. If not, then it is possible that the town requires a state abbreviation. Therefore, in step 142 a message "STATE:" is displayed to the operator so that the operator may enter the name of the state which is received in step 143. The files are then searched in step 144 for the town and state. If the town and state are not found, then execution jumps to steps 138 and 139 so that the user may try again to enter the name of the town.

Returning now to FIG. 13, in step 145 the town including the point of origin (A-TOWN) is set to the town received from the user. Then in step 146 a message "WHERE:" is displayed to the operator to prompt for the entry of two road names intersecting at the point of origin. Then in step 147, a subroutine "R" is called to enter the name of the first road at the intersection.

Turning for the moment to FIG. 15, there is shown a flowchart of the subroutine "R". In the first step 148, the name of the road is received from the operator. In step 149, the road file for the previously entered town is searched and if the road is not found in the road file, then in step 150 the operator is told to try again and in step 151 the keyboard is scanned to receive another name for the road.

If in step 149 the road name is found in the road file, then in step 153 the road type associated with the road name in the file is inspected to determine whether the road is a square. If so, execution returns in a different manner since the point of origin can be determined from the coordinates of the square without requesting the name of a second road from the user.

Returning now to FIG. 13, in step 154 the parameter A1-ROAD is set equal to the name of the road or square obtained from the subroutine "R". Then, if the road is not a square, in step 155 the message "AT:" is displayed to the operator in order to prompt for the second road determining the intersection of the point of origin. The name of the second road is obtained in step 156 by again calling the subroutine "R". Then, in step 157, the parameter "A2-ROAD" is set equal to the name of the road obtained from the subroutine "R". Next, in step 158, the beginning and ending points of the segments for the two roads A1-ROAD and A2-ROAD are compared to determine whether a segment of A1-ROAD crosses a segment of A2-ROAD. If not, then in step 159 the operator is told that the roads do not cross and he must try again to enter the names for the two roads, and execution jumps to step 146 to prompt for the new road names.

If in step 158 it is found that the two roads cross, then in step 160 the message "TO:" is displayed to the operator to prompt for the town including the desired point of destination. The town of the point of destination is obtained and the point of destination itself is obtained in steps 161 to 169 which are similar to steps 134 to 158. Finally, in step 171, the message "IN PROCESS" is displayed to the operator to indicate that the control procedure is being executed to search for a path having substantially a minimum travel time from the specified point of origin to the desired point of destination.

Turning now to FIG. 16, the flowchart of the preferred control procedure continues. In step 172, the coordinates of the beginning and ending points of the first road at the point of origin are read from the road files, and in step 173 the coordinates of the beginning and ending points of the second road at the point of origin are also read. From the beginning and ending points of each road segment, in step 174 the coordinates XA, YA of the point of origin at the intersection are calculated. Similarly, to determine the coordinates of the desired point of destination, the coordinates of the beginning and ending points of the first road at the point of destination are read in step 175 from the road file, and in step 176 the coordinates of the beginning and ending points of tne second road segment at the point of destination are also read from the road files. In step 177, the coordinates XZ, YZ of the point of destination are calculated as the point of intersection, In step 178, the distance RD between the point of origin and point of destination is calculated by applying the Pythagorean formula to the differences of the respective coordinates of the point of origin and the point of destination. In step 179, an expected travel time RT is calculated as proportional to the distance RD. In step 180, the angle RA of the reference line including the point of origin and point of destination, is calculated with respect to the X-axis which is in the eastern direction.

At this point in the control procedure, the problem has been defined in terms of the coordinates XA and YA of the point of origin, the coordinates XZ and YZ of the point of destination, the distance RD between the origin and destination, the iteration time limit RT, and the angle RA of the reference line with respect to the X-axis.

Turning now to FIG. 17, the control procedure continues with steps to find a main road MA in the area of the point of origin. This is done by searching the road files for roads having high speed, an angle AI with respect to the X-axis that is about the same as the angle RA, and a minimum distance from the point of origin. These factors are taken into consideration by a formula such as:

$$f(S,AI,DA,DZ,RA) = t*S - DA - 0.1*DZ - x(AI-RA)^2$$

In this formula, the parameter x should be selected in proportion to the size of the town, and for example is five miles. The parameter t should be selected on the basis of the density of main roads, and, for example, has a value of 0.2 hours. The best main road should have a maximum value of this function, consistent with certain other constraints which more quickly eliminate particularly poor main roads.

In the first step 191 of the flowchart in FIG. 17, certain parameters are set to initial values. Then in step 192, the parameters of the elipse having the point of origin and point of destination as foci, with the size of the elipse being proportional to RD, are computed. The elipse, for example, consists of all points for which the distance of each point to the point of origin plus the distance of the point to the point of destination is equal to a certain factor such as 1.5 times the distance RD. The parameters are the quadratic coefficients of the equation specifying this elipse, and they are computed in order to quickly determine, as further described below, whether any point of a given road is within the elipse.

Continuing now in the next step 193, execution branches depending upon whether the point of origin and point of destination are included in the same town, or whether the first slot (26 in FIG. 1) does not include a data cartridge. If so, then in step 194, the data files in the main bank (51 in FIG. 3) are used in finding the best main road MA associated with the point (A) of origin. Otherwise, the data files in the first data cartridge (25 in FIG. 1) are selected in step 195 to be used in selecting the best main road.

An iterative search procedure starts in step 196, in which the data for the next main road indicated by the current value of an index pointer I are read from either the main bank, or the first data cartridge, as previously selected in either step 194 or step 195. Execution then branches in step 197 depending upon whether an iterative search is being performed for major roads (the case when L = 0) or for minor roads (for the case of L = 1) and depending upon whether the speed S for the road is greater than or less than or equal to 80 kilometers per hour, which is used as a threshold value to determine whether a particular road is a major road or a minor road. Execution branches to step 198 for the case of a major road. In step 198, the angle AI of the main road with respect to the X axis is determined. Then, in step 199, the main road is rejected as the best main road if the angle between the main road and the reference line is greater than 30°. Otherwise, in step 200, the main road is rejected from further consideration if it lies outside of the elipse mentioned above in connection with step 192. If a point of the main road lies within the elipse, then in step 201 the minimum distance DA of the main road from the point of origin (A) is calculated and also the minimum distance (DZ) of the main road from the point of destination (Z) is calculated. Then, the parameters for the main road are inserted in the formula f(S,AI,DA,DZ,RA) mentioned above, and this formula is evaluated in step 202 to obtain a value V which is a maximum for the best road. In order to determine the particular road having the maximum value, in step 203 the value V is compared to the up-to-then value BV. If the just-computed value V is not less than the up-to-then value BV, then in step 204, the parameter BR is set equal to the index I of the main road currently being considered to record the fact that it is a better road, and the up-to-then value BV is set equal to the value V for future comparison.

Next, in step 205, the index I is incremented and the end of the road file for the town including the point of origin is tested in step 206 to determine whether all of the pertinent roads have been considered. If not, execution branches back to step 196 for the next iteration.

Upon reaching the end of the file in step 206, in step 207 the parameter BV is compared to zero to determine whether any main roads were found. If not, then in step 209 the parameter L is set equal to 1 to start the search procedure over again, this time looking for roads that are slower than the 80 kilometer per hour threshold.

Once the best main road is found in step 207, then in step 210 the parameter START is compared to the value of "A". If START has a value of "A", which should be true at this time during the search for the main road MA, then execution branches to step 211 to record the fact that the index of the main road MA is presently stored in the parameter BR.

At this time, the control procedure searches for a main road MZ in the town including the point of destination (Z). However, as tested in step 212, if the distance DZ is small enough, considering the distance RD (for example, less than 0.1 times RD), then it is expeditious to assume that the best main road MZ should be the same as the main road MA. Therefore, in this case, execution branches to step 213 to record this fact. Otherwise, execution branches to step 214 which resets certain parameters in order to use the same iterative procedure as described above to find the best main road MB leading from the town including the point of destination.

Turning now to FIG. 18, there is shown the portion of the control procedure generally designated 116 which finds a good path from the point of origin (A) to the first main road (MA). To do this, the control procedure finds the coordinates of P1, the intersection between the first main road (MA) and a straight line through the point of origin (A), at 30° with respect to the reference line. This is done in steps 221, 222, 223, and 224. Next, in step 225, the control procedure finds the coordinates of P2, the intersection point between the first main road (MA) and a straight line through the point of origin (A), at 105° with respect to the reference line. In step 226, the previously used search parameters are reset to initial values.

The iterative search procedure starts in step 227 by reading data for the next road. Next, in step 228, the coordinates of the beginning and ending points of the next road are compared to the coordinates of the points P1 and P2 to determine whether the road intersects the main road MA at a point between the points P1 and P2. Also, it is determined whether traffic may flow in the proper direction along the road (#I) to the main road MA. If not, the road (#I) is rejected as a candidate for a good path from the point of origin (A) to the first main road (MA). Otherwise, execution continues in step 229.

The angle AL of the road (#I) with respect to the X-axis is computed, along with the minimum distance (DA) of the road from the point of origin (A). Then, in step 300, the function f(S,AL,DA,0,RA) is evaluated. In step 301, the value v of this function is compared to the up-to-then best value BV in order to find the best value for all of the roads under consideration. If the value v is not less than the up-to-then best value (BV), then execution branches to step 302 to record that the present value of the index I points to the up-to-then best road (BR), and the up-to-then best value is set equal to the present value V.

Next, in step 303, the index I is incremented for the next iterative step. The end of the road file is tested in step 304, and execution jumps back to step 227 to again iterate unless the end of file is reached. In this case, in step 305, the iterative procedure is set up to be recursively performed, by storing the best road VR in the location START + 1 of

an array MA. If the best road BR crosses the point of origin (A), as tested in step 306, the recursive application of the iterative procedure is terminated. Otherwise, in step 307, the search parameters are set to new initial values to reiterate for the next level of recursion.

Each level of recursion selects the next road in a chain of best roads leading from the point of origin to the initial main road which is indicated by the pointer in the zero location of the array MA. This array was initially set in step 221.

Turning now to FIG. 19, step 117 of finding a good path from the point of destination (Z) to the second main road (MZ) is performed in the same fashion as shown in FIG. 18, except the point of destination (Z) is used instead of the point of origin (A), and the second main road (MZ) is used in lieu of the first main road (MA).

Next, the basic step 118 of finding a good path connecting the first main road (MA) and the second main road (MZ) is performed. Initially in step 311 MA and MZ are compared, or the coordinates of the end points of these two roads and any respective anomalous knot or one-way conditions are checked to determine whether the two main roads MA and MZ are identical or intersect one another to permit the flow of traffic from the point of origin to the point of destination. If so, the path connecting MA and MZ has already been established. If not, then in step 312 the point PZ is determined as the point of the main road MZ closest to the point of origin, and the point PA is determined as the point of the first main road MA closest to the point of destination. Then, the entire procedure shown in FIG. 18 is repeated in step 313 using PA and PZ instead of the point of origin (A) and the point of destination (Z), respectively.

Now that a complete path has been determined, in step 119 the better of the best prior route and the current route is selected. In step 314, the total travel time of the present route under consideration is computed and stored in the parameter TT, and also the total distance of travel along that path is computed and stored in the parameter TD. Then, in step 315, the total travel time (TT) is compared to the up-to-then best travel time (BT). If TT is less than BT, then the current path is better than the up-to-then best path, and the travel time TT is stored in the parameter BT, and the pointers to the roads and the coordinates of the intersections between the roads and the path just determined is stored in an array in step 316.

In step 317, the up-to-then best travel time (BT) is compared to the expected travel time (RT) in order to terminate the overall search procedure if the time BT is less than the time RT. If so, the results are displayed at step 121. Otherwise, in step 318, the rsults are also displayed if there are enough paths or overall iterations that have already been considered. It is found, for example, that no less than about 30 complete paths must be found in order to find the path having substantially the minimum travel time. Therefore, in step 318, the number of paths considered is compared to a predetermined number such as 30. If in step 318 it is found that an insufficient number of paths have been found for comparison purposes, then in step 319 the entire process is repeated in step 319. Specifically, in step 319, execution jumps back to step 191, but the initial value of the index I is set to 2 if the best main road MA has a value of 1, or the increment step 205 is modified to skip a previously considered best main road (MA). Also, on alternate times that step 319 is executed, execution jumps to step 226 instead and the initial value of the index I is set to 2 in step 214 if the second main road MA having an index of 1 has already been considered, or in step 205 the previously considered second main roads (MB) are skipped. Therefore, during successive iterations of the overall search procedure restarted from step 319, the search procedure is repeated by considering successively poorer and poorer best main roads. This completes the description of the preferred search procedure for finding a path from the specified point of origin to the desired point of destination having a substantially minimum travel time.

In view of the above, there has been described an economical automotive navigation computer which determines the best route to take given a vehicle's point of origin and the desired point of destination expressed in terms of street addresses or intersections. Although the description above assumed that the point of origin and point of destination were given as the intersection of respective streets, it should be apparent that street addresses could be used by providing additional memory storing data which correlates street addresses to the nearest intersecting roads. The automotive navigation computer is especially economical because the data organization is capable of storing an abstract representation of the road network in a reduced memory space. It is entirely economical to store, for example, an abstract representation of the interstate highway system for the United States in a main memory bank, and to provide a pair of interchangeable data cartridges for storing an abstract representation of the major and minor roads. One cartridge is used for storing an abstract representation of the major and minor roads in an area including the point of destination, and a second data cartridge is used for storing an abstract representation of the major and minor roads in a second area including the desired point of destination.

0246452

# CLAIMS

1. A method of eliminating the use of maps by the operator of a motor vehicle who wishes to travel over roads within a certain territory from a given point of origin to a desired point of destination along a route having a minimum travel time, characterized in that said method comprises the steps of:

a) providing a data processor completely contained within said motor vehicle, said data processor having a central processing unit and a memory containing a set of instructions which are executed by said central processing unit, said memory also storing an abstract representation of the network of said roads within said territory,

said data processor further including a manually-operated input means for receiving from said operator said given point of origin and said desired point of destination,

said set of instructions including a procedure executed by said central processing unit for interpreting said abstract representation of said network of roads to iteratively search for and find a first path of said roads connecting said given point of origin and said desired point of destination received by said input means, compute the travel time along said first path, search for and find a second path of said roads connecting said given point of origin and said desired point of destination received by said input means, compute the travel time along said second path, select the path having the smaller travel time, and iterate said searching, finding, computing and selecting to determine a path having substantially the minimum travel time between said given point of origin and said desired point of destination, and

said data processor further including output means for providing said operator with information for guiding said motor vehicle along said path having substantially the minimum travel time,

b) manually operating said input means to receive said given point of origin and said desired point of destination, and

c) guiding said motor vehicle in response to the information provided by said output means to thereby guide said motor vehicle along said path having substantially the minimum travel time between said given point of origin and said desired point of destination.

2. The method as claimed in claim 1, characterized in that the abstract representation of the network of said roads in said territory includes a list of segments of said roads in said network and respective properties and conditions for said road segments including one-way conditions and in that the procedure searches for and finds paths of said roads which are consistent with the conditions of the road segments included in said paths.

3. The method as claimed in claim 1 or 2, characterized in that the abstract representation of the network of said roads in said territory includes a list of intersections of pairs of said roads which have restrictions on the flow of traffic from one road to the other, and for each of said intersections data indicating specified ones of the eight possible restrictions on the flow of traffic from one road to the other.

4. The method as claimed in claim 2, characterized in that the respective properties for said road segments include the coordinates of the end points of said road segments, the average travel speed along said road segments, and the length of travel along the road sections represented by said road segments;

and in that

the procedure for searching for said paths of roads determines whether pairs of said road segments intersect from the coordinates of the end points of said pairs of said road segments, and computes the coordinates of intermediate points of intersection from the coordinates of the end points of said pairs of said road segments.

5. The method as claimed in anyone of the preceding claims, characterized in that abstract representation of the network of said roads in said territory includes the names of towns included within said territory, information identifying said road segments within said towns, and information identifying whether said road segments are parts of main roads ; and in that the procedure for searching for and finding said paths of roads determines respective first and second towns including said point of origin and said point of destination, finds respective main roads leading out of said towns, finds respective paths within said towns connecting the respective points to the respective main roads, and finds a path connecting the main roads.

6. The method as claimed in anyone of the preceding claims, characterized in that the memory includes a main memory bank, and first and second interchangeable data cartridges, said main memory bank storing an abstract representation of the network of said main roads, and said first and second interchangeable data cartridges storing the abstract representation of the network of roads within the respective first and second towns; said method including the step of said operator selecting said first and second interchangeable data cartridges and connecting said data cartridges to said data processor.

7. The method as claimed in anyone of the preceding claims from 1 to 5, characterized in that the memory includes a main memory bank storing an abstract representation of main roads in said territory, and said data processor includes means for selectively receiving at least two interchangeable data cartridges storing abstract representations of main roads and minor roads within respective limited areas of said territory; said method including the steps of said operator selecting, for use with said means for receiving, a first data cartridge storing abstract representations of main roads and minor roads within a limited area of said territory including said point of origin, and said operator selecting, for use with said means for receiving, a second data cartridge storing abstract representations of main roads and minor roads within a limited area of said territory including said point of destination.

8. The method as claimed in anyone of the preceding claims, characterized in that the given point of origin and said desired point of destination are received from said operator by said means for receiving as respective pairs of names of roads, said points being interpreted by said central processing unit as the points of intersection of said respective pairs of roads.

9. An automotive navigator (20) for use in a motor vehicle in carrying out the method according to anyone of the preceding claims, characterized in that it comprises, in combination:

a data processor having a central processing unit (28) and a memory (29, 30, 37) containing a set of instructions which are executed by said central processing unit, said memory also storing an abstract representation of the roads within a certain territory, said abstract representation including a list of segments of said roads and respective properties and conditions for said road segments, and a list of intersections of pairs of said roads which have restrictions on the flow of traffic from one road to the other,

a manually-operated input means (25,27) for receiving from said operator information defining a specified point of origin and a desired point of destination, and

an output means for providing said operator with directions on how to drive along a selected path of said roads,

wherein said set of instructions executed by said central processing unit includes a procedure for obtaining said information received by said input means, interpreting said abstract representation of said roads to select a path from said point of origin to said point of destination consistent with said conditions and restrictions and having a substantially minimum travel time, and generating and transmitting to said operator via said output means directions on how to drive along the selected path having a substantially minimum travel time, wherein said procedure searches for and finds said path having a substantially minimum travel time by interatively selecting roads, combining roads to form paths from the point of origin to the point of destination, computing the travel time along said paths, and comparing the travel times to select the path having a minimum travel time.

10. The apparatus as claimed in claim 9, wherein said abstract representation of the network of said roads in said territory includes the names of towns included within said territory, and information identifying said road segments within said towns;

said procedure combines roads to form said paths from the point of origin to said point of destination by determining respective first and second towns including said point of origin and said point of destination, finding respective main roads leading out of said towns, finding respective paths within said towns connecting the respective points to the respective main roads, and finding a path connecting the main roads, and

said memory includes a main memory bank, and first and second interchangeable data cartridges, said main memory bank storing an abstract representation of the network of said main roads, and said first and second interchangeable data cartridges storing the abstract representation of the network of roads within the respective first and second towns.

11. The apparatus as claimed in claim 9 or 11, wherein said given point of origin and said desired point of destination are received from said operator by said means for receiving as respective pairs of names of roads, said points being interpreted by said central processing unit as the points of intersection of said respective pairs of roads.

12. The automotive navigator as claimed in anyone of the preceding claims 9 to 11, wherein said automotive navigator (20) is portable.

13. The apparatus as claimed in anyone of the preceding claims from 9 to 12, wherein said memory includes programmable nonvolatile memory (37), and said procedure includes instructions for obtaining from said input means information supplied by said operator to update said abstract representation of roads, storing said operator-supplied information in said nonvolatile memory, and for preferentially reading said operator-supplied information from said nonvolatile memory when interpreting said abstract representation of said roads.

14. The apparatus as claimed in anyone of the preceding claims from 9 to 13, wherein said memory includes programmable nonvolatile memory (37), and said procedure includes instructions for obtaining from said input means information about the location of a home address, storing said home address in said nonvolatile memory, and selecting said home address stored in said nonvolatile memory as either said point of origin or said point of destination in response to respective commands entered by said operator via said input means.

15. The apparatus as claimed in anyone of the preceding claims from 9 to 14, characterized in that it comprises means for sensing displacement of said motor vehicle, and wherein said directions on how to drive along said selected path are generated in response to the vehicle displacement sensed by said means for sensing.

16. The apparatus as claimed in anyone of the preceding claims from 9 to 15, wherein said central processing unit is linked to a vehicle maintenance computer (38) for said vehicle so that said operator may use said input means and said output means for communicating with said vehicle maintenance computer to obtain the status of said vehicle.

17. The apparatus as claimed in anyone of the preceding claims from 9 to 16, wherein said central processing unit is linked to a mobile radio receiver (36) for obtaining information about the status of certain of said roads in said territory which is taken into consideration during the searching and finding of said path having a substantially minimum travel time.

18. The apparatus as claimed in anyone of the preceding claims from 9 to 17, wherein said output means includes a graphic display (31) for displaying a graphic representation of at least a portion of said roads within the vicinity of said path having a substantially minimum travel time.

19. The apparatus as claimed in anyone of the preceding claims from 9 to 18, wherein said output means includes a speech synthesizer (33) for having said operator verbal directions along said path having a substantially minimum travel time.

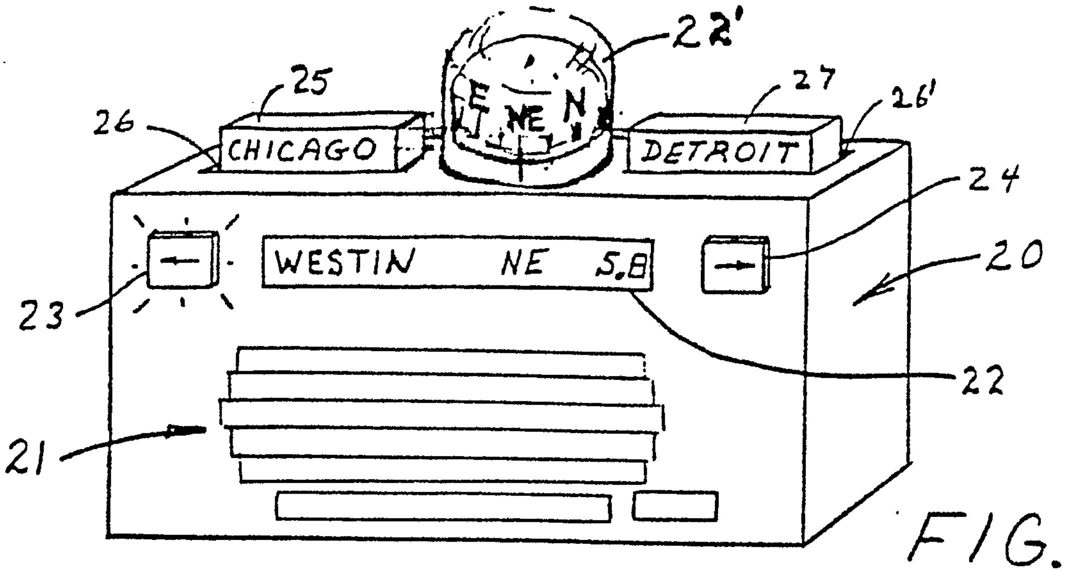


FIG. 1

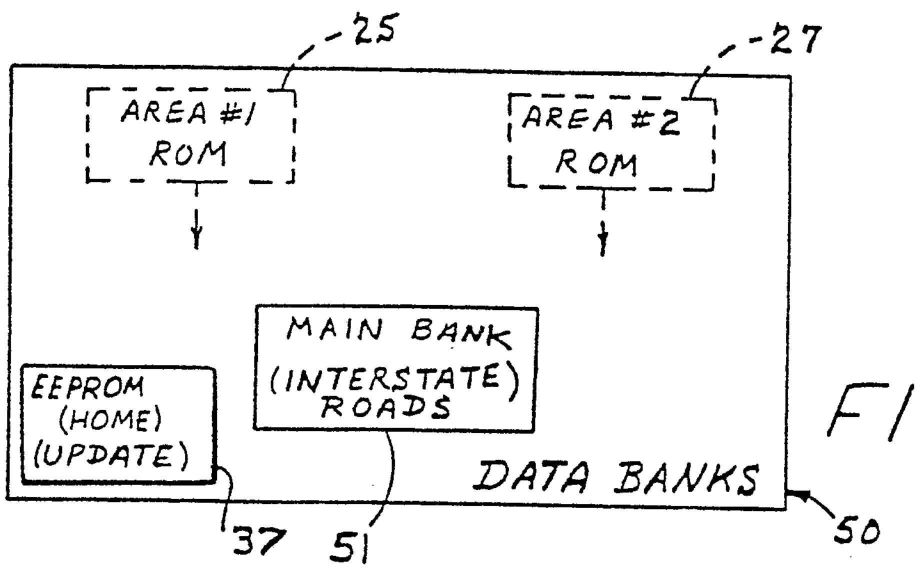


FIG. 3

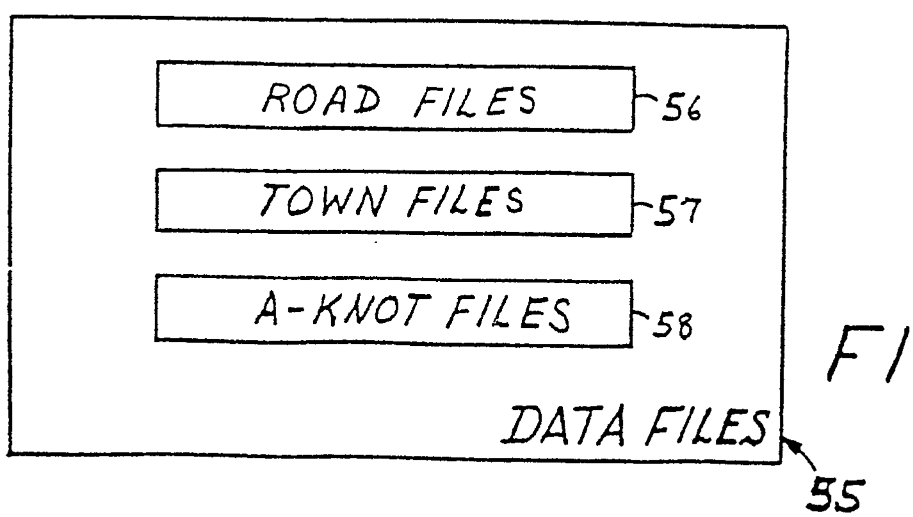


FIG. 4

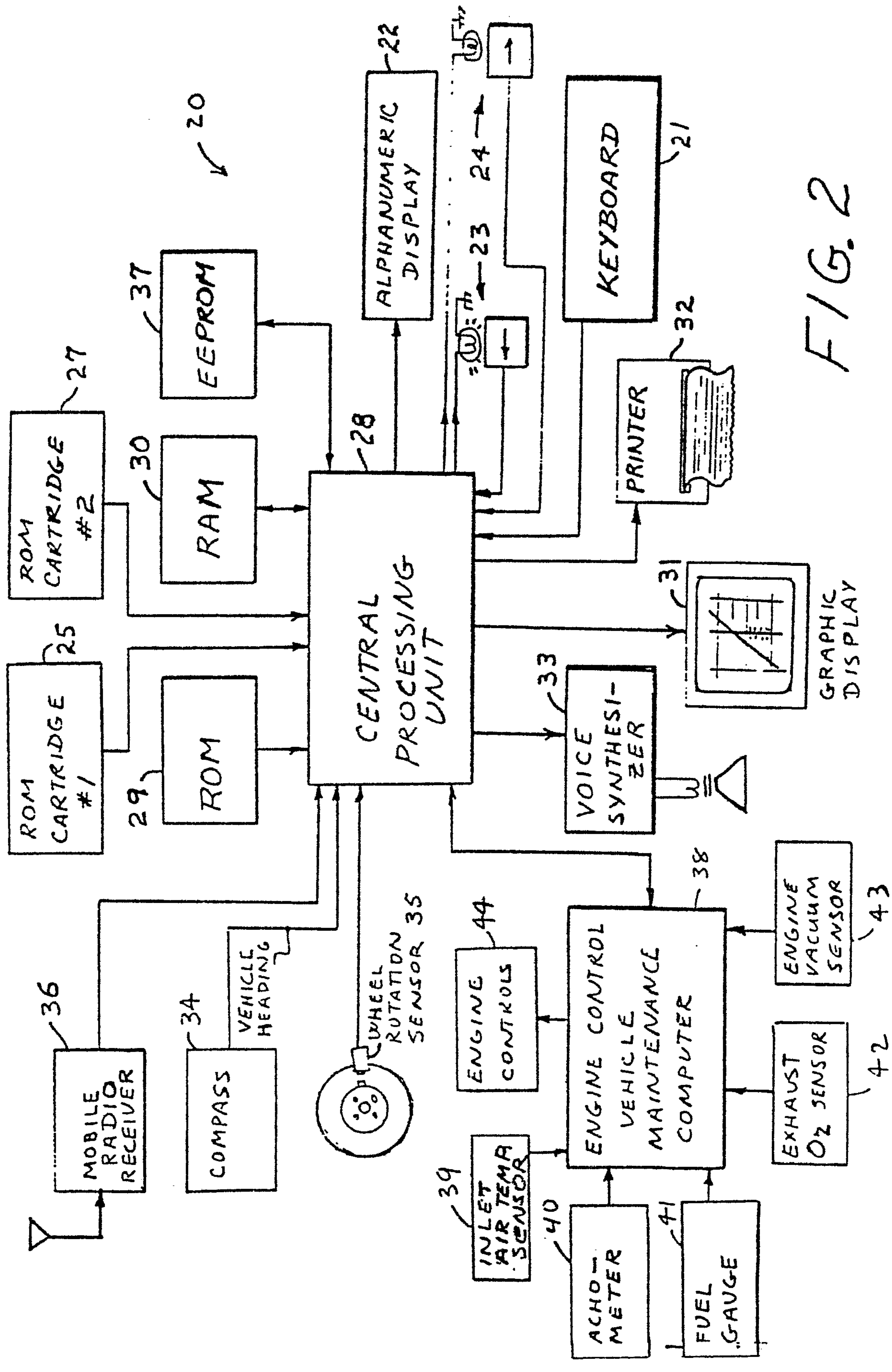
20
ALPHANUMERIC DISPLAY
22
24
23
KEYBOARD
21
EEPROM
37
ROM CARTRIDGE #2
27
RAM
30
28
PRINTER
32
ROM CARTRIDGE #1
25
ROM
29
CENTRAL PROCESSING UNIT
31
GRAPHIC DISPLAY
VOICE SYNTHESIZER
33
38
MOBILE RADIO RECEIVER
36
COMPASS
34
VEHICLE HEADING
WHEEL ROTATION SENSOR 35
ENGINE CONTROLS
44
ENGINE CONTROL VEHICLE MAINTENANCE COMPUTER
ENGINE VACUUM SENSOR
43
EXHAUST O2 SENSOR
42
INLET AIR TEMP SENSOR
39
ACHO-METER
40
FUEL GAUGE
41

FIG. 2

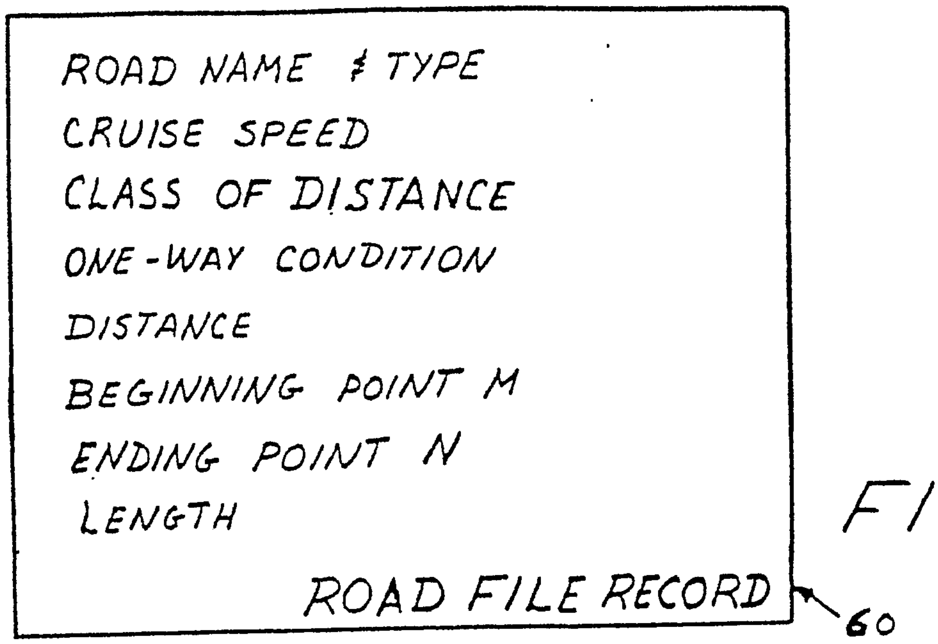


FIG. 5

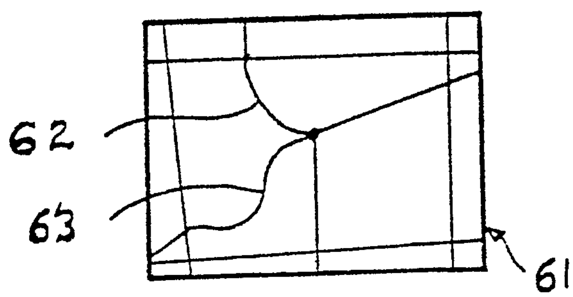


FIG. 6

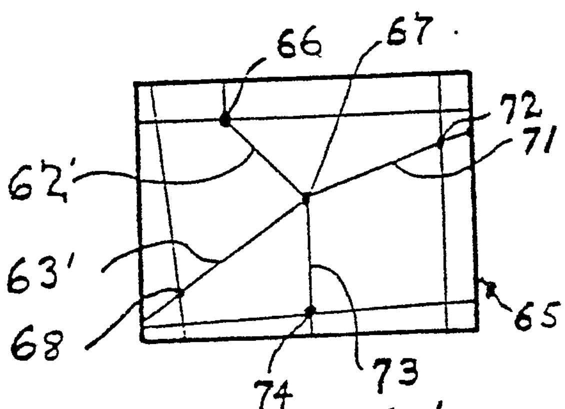


FIG. 7

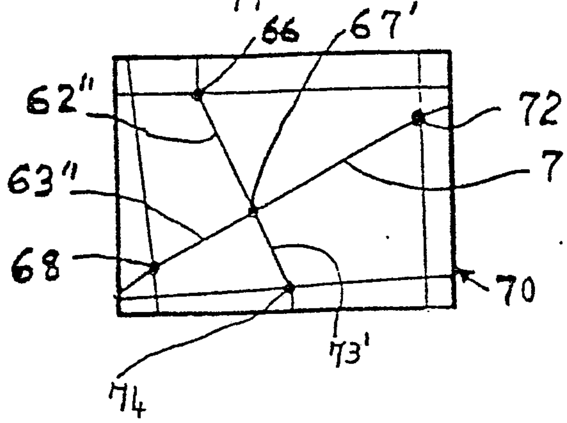


FIG. 8

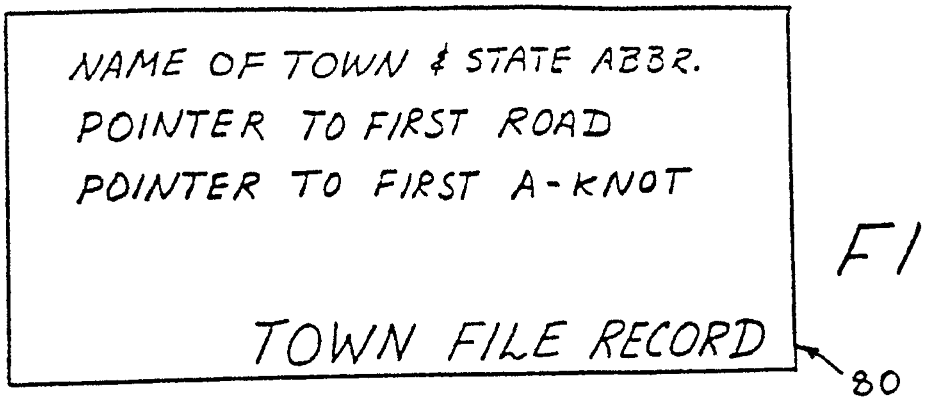


FIG. 9

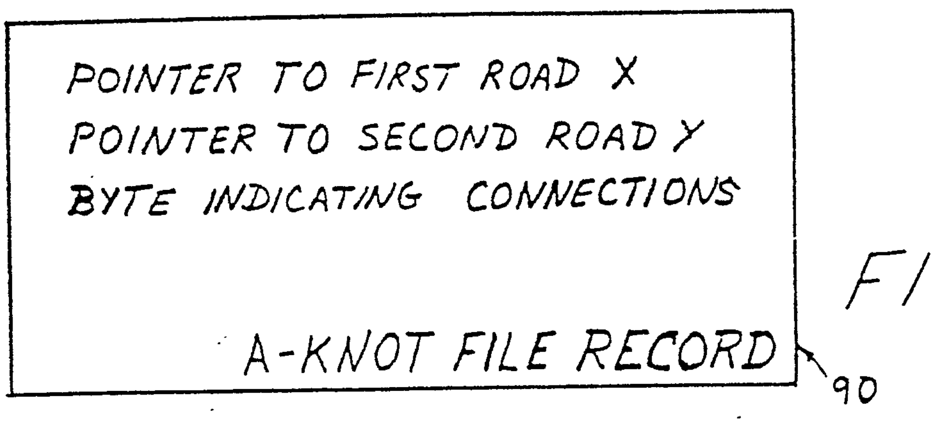


FIG. 10

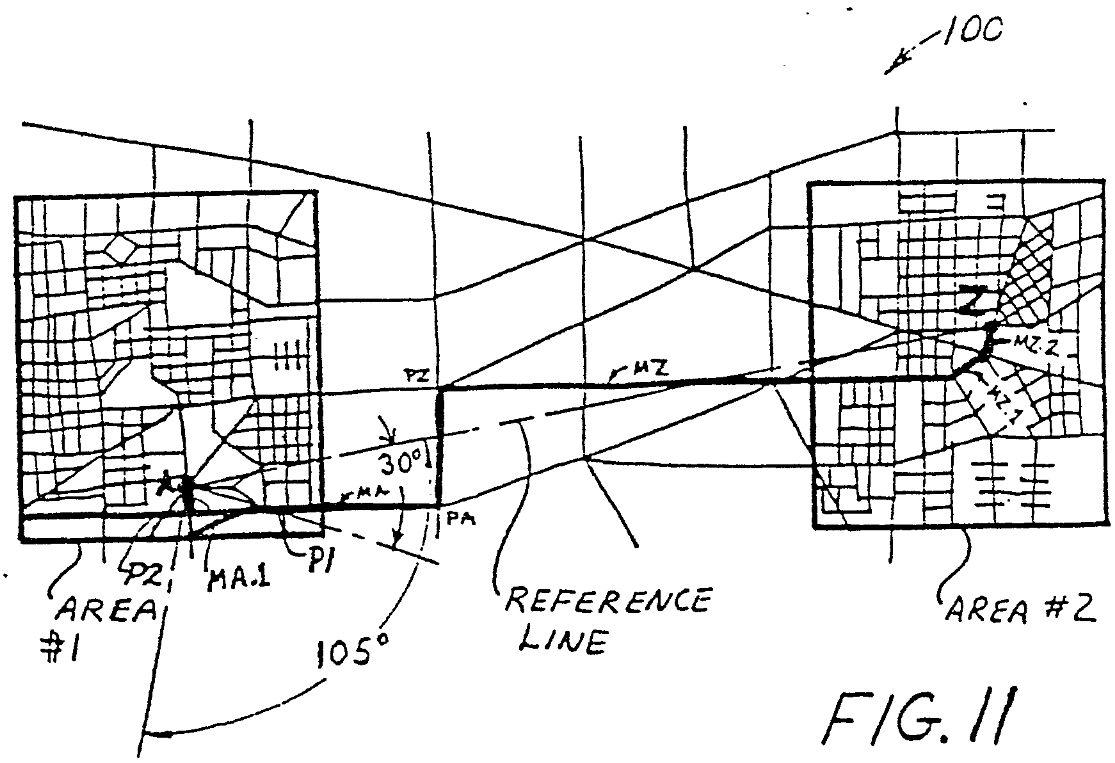


FIG. 11

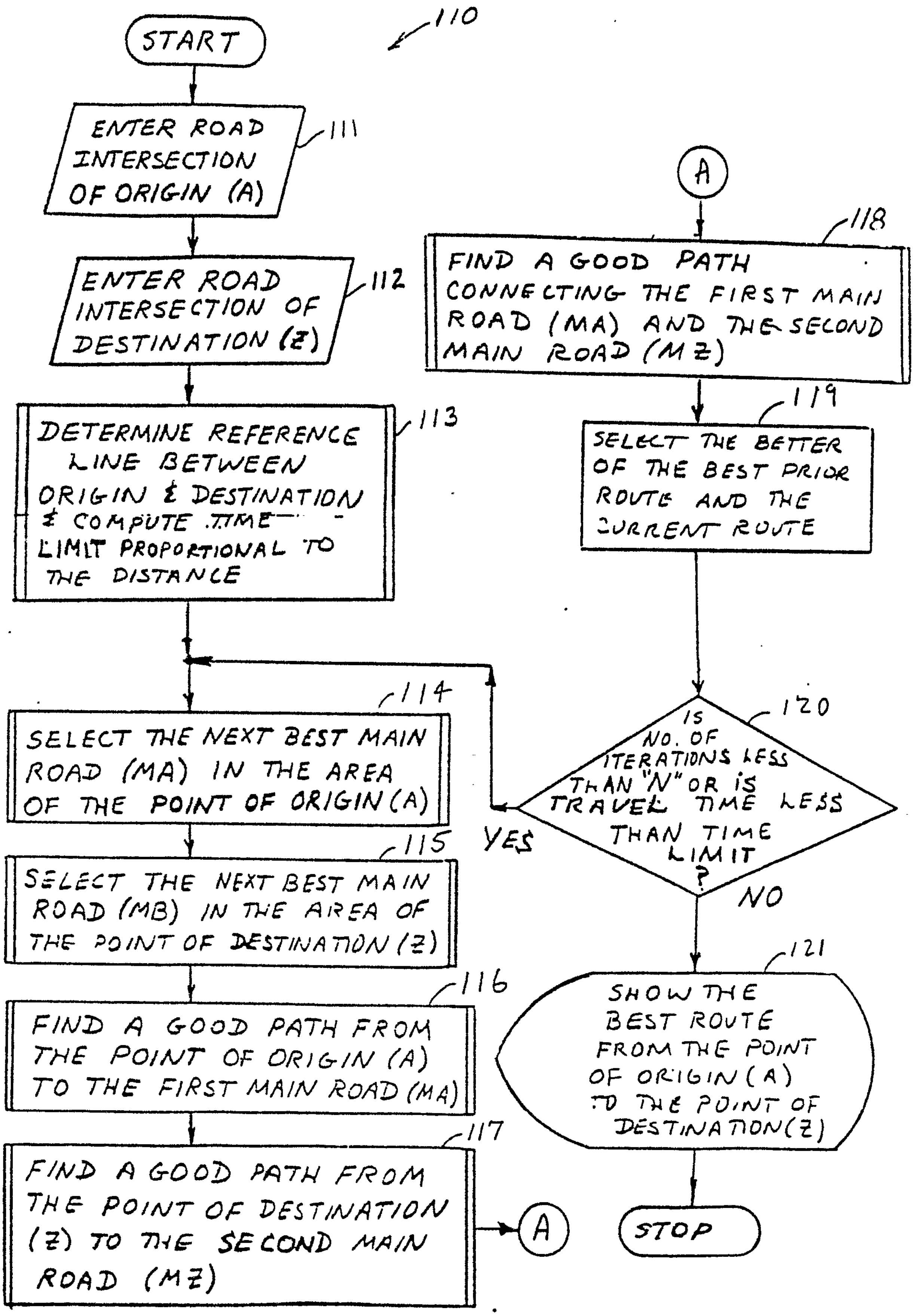
110
START
ENTER ROAD INTERSECTION OF ORIGIN (A)
111
ENTER ROAD INTERSECTION OF DESTINATION (Z)
112
DETERMINE REFERENCE LINE BETWEEN ORIGIN & DESTINATION & COMPUTE TIME LIMIT PROPORTIONAL TO THE DISTANCE
113
SELECT THE NEXT BEST MAIN ROAD (MA) IN THE AREA OF THE POINT OF ORIGIN (A)
114
SELECT THE NEXT BEST MAIN ROAD (MB) IN THE AREA OF THE POINT OF DESTINATION (Z)
115
FIND A GOOD PATH FROM THE POINT OF ORIGIN (A) TO THE FIRST MAIN ROAD (MA)
116
FIND A GOOD PATH FROM THE POINT OF DESTINATION (Z) TO THE SECOND MAIN ROAD (MZ)
117
A
A
FIND A GOOD PATH CONNECTING THE FIRST MAIN ROAD (MA) AND THE SECOND MAIN ROAD (MZ)
118
SELECT THE BETTER OF THE BEST PRIOR ROUTE AND THE CURRENT ROUTE
119
IS NO. OF ITERATIONS LESS THAN "N" OR IS TRAVEL TIME LESS THAN TIME LIMIT ?
120
YES
NO
SHOW THE BEST ROUTE FROM THE POINT OF ORIGIN (A) TO THE POINT OF DESTINATION (Z)
121
STOP

FIG 12

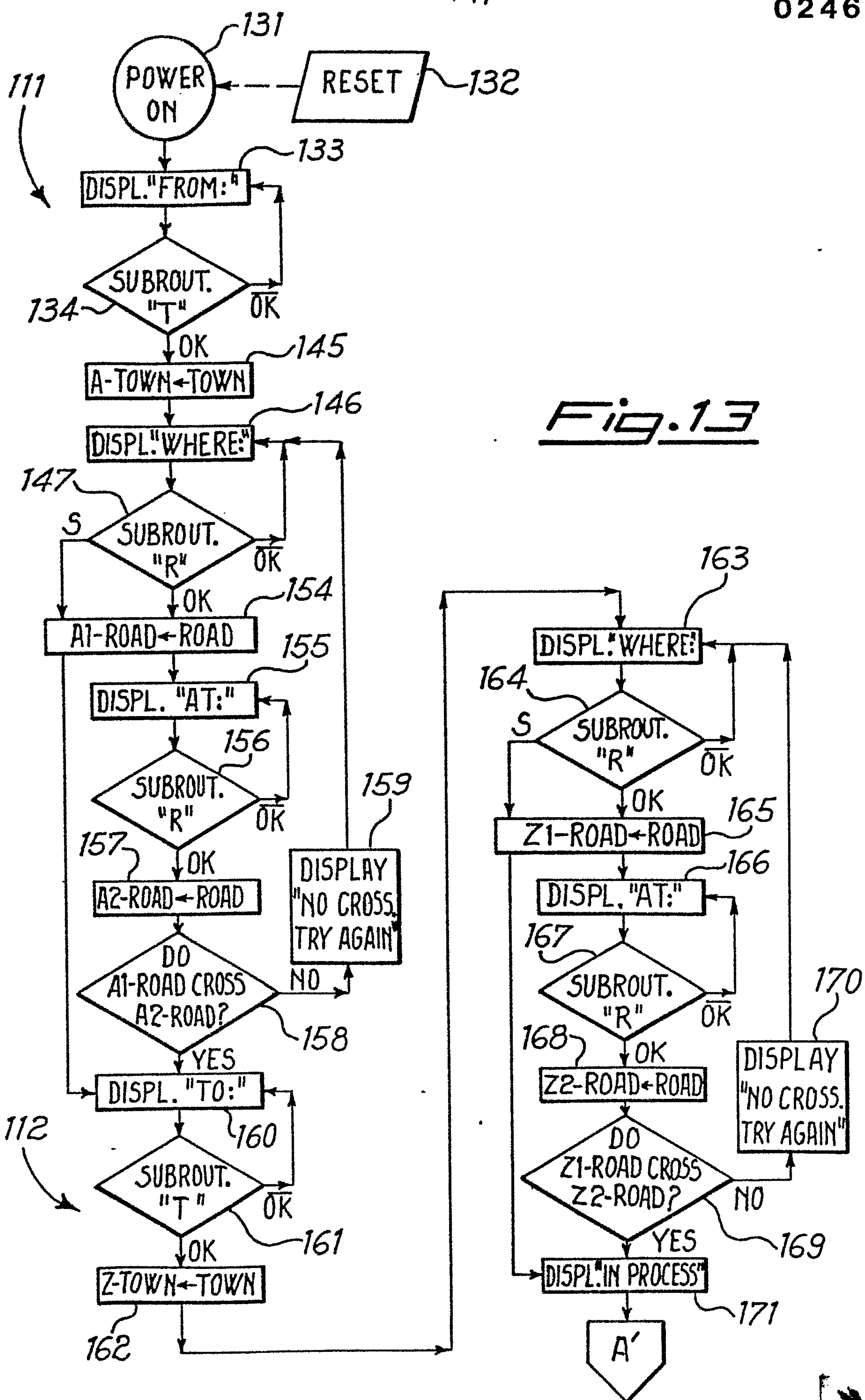
131
POWER ON
RESET
132
111
DISPL."FROM:"
133
SUBROUT. "T"
OK
134
OK
A-TOWN←TOWN
145
DISPL."WHERE:"
146
147
S
SUBROUT. "R"
OK
OK
A1-ROAD←ROAD
154
DISPL. "AT:"
155
SUBROUT. "R"
156
OK
OK
157
A2-ROAD←ROAD
DISPLAY "NO CROSS. TRY AGAIN"
159
DO A1-ROAD CROSS A2-ROAD?
NO
158
YES
DISPL. "TO:"
160
112
SUBROUT. "T"
OK
161
OK
Z-TOWN←TOWN
162
163
DISPL."WHERE:"
164
S
SUBROUT. "R"
OK
OK
Z1-ROAD←ROAD
165
DISPL. "AT:"
166
167
SUBROUT. "R"
OK
168
OK
Z2-ROAD←ROAD
170
DISPLAY "NO CROSS. TRY AGAIN"
DO Z1-ROAD CROSS Z2-ROAD?
NO
YES
169
DISPL."IN PROCESS"
171
A'

Fig.13

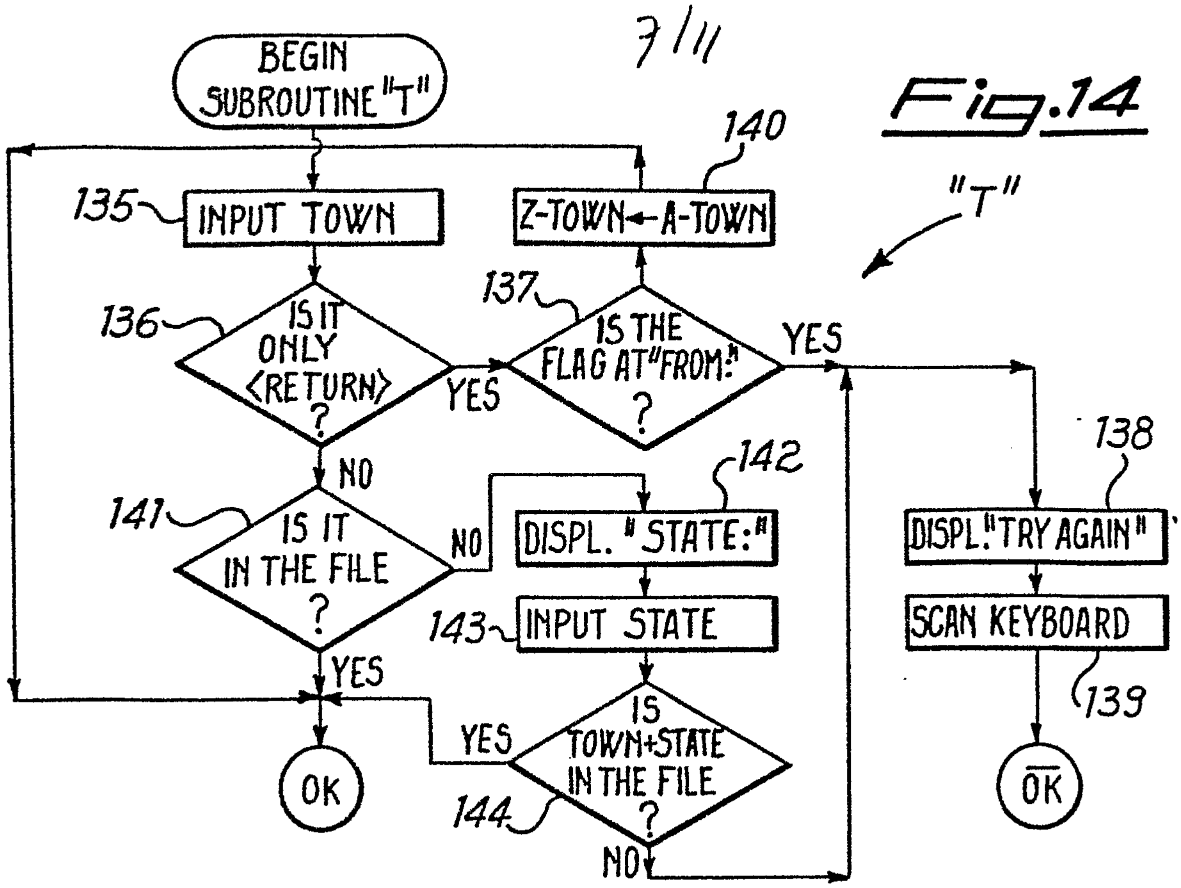
BEGIN SUBROUTINE "T"
135
INPUT TOWN
136
IS IT ONLY <RETURN> ?
YES
NO
137
IS THE FLAG AT "FROM:" ?
YES
140
Z-TOWN ← A-TOWN
141
IS IT IN THE FILE ?
NO
YES
142
DISPL. "STATE:"
143
INPUT STATE
144
IS TOWN+STATE IN THE FILE ?
YES
NO
OK
138
DISPL. "TRY AGAIN"
SCAN KEYBOARD
139
$\overline{OK}$
"T"

Fig.14

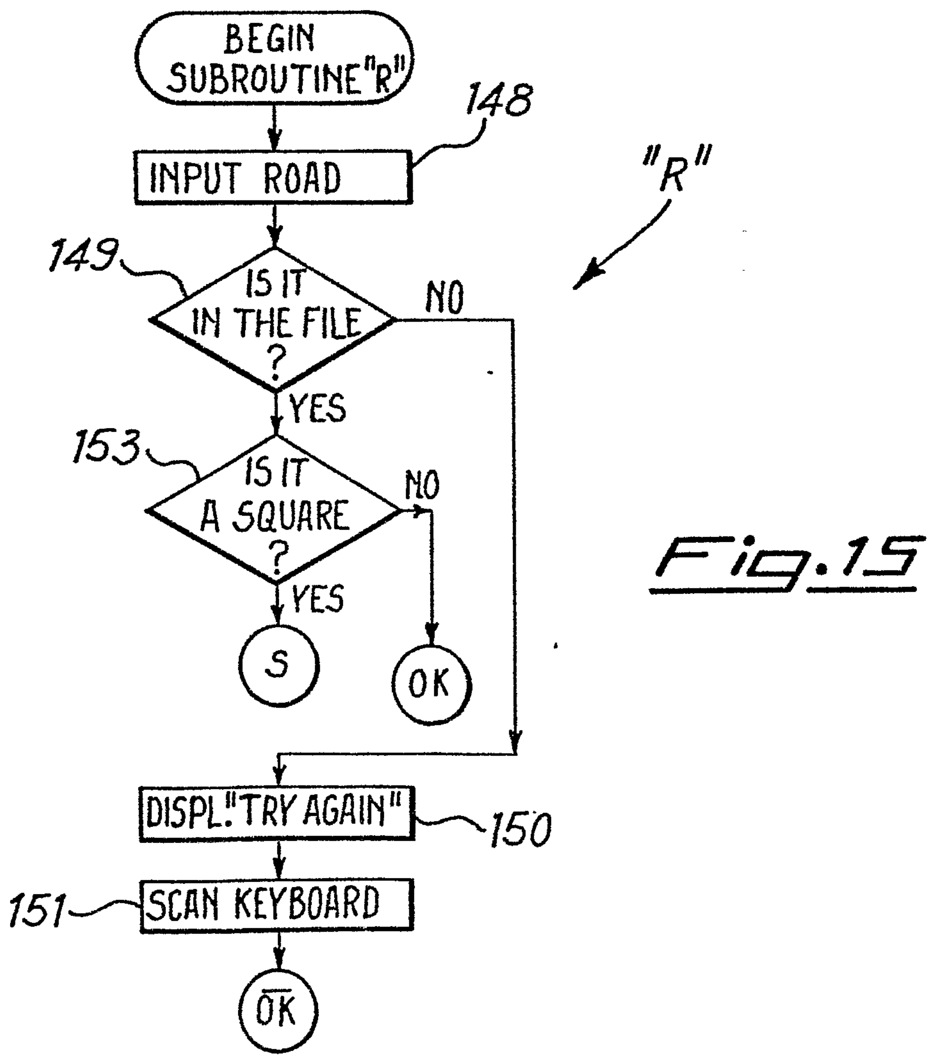
BEGIN SUBROUTINE "R"
148
INPUT ROAD
149
IS IT IN THE FILE ?
NO
YES
153
IS IT A SQUARE ?
NO
YES
S
OK
DISPL. "TRY AGAIN"
150
151
SCAN KEYBOARD
$\overline{OK}$
"R"

Fig.15

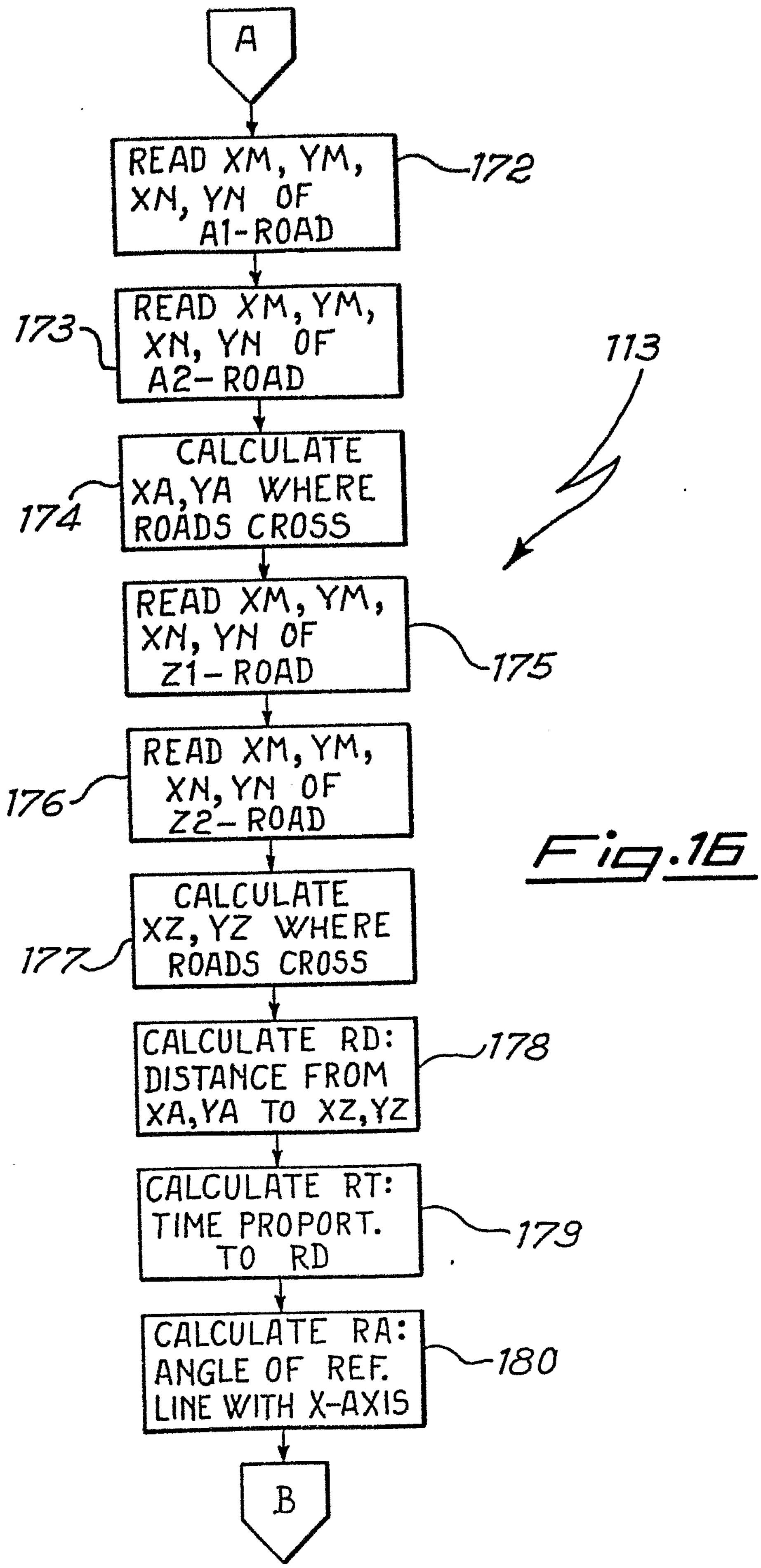

A
READ XM, YM, XN, YN OF A1-ROAD
172
READ XM, YM, XN, YN OF A2-ROAD
173
CALCULATE XA,YA WHERE ROADS CROSS
174
113
READ XM, YM, XN, YN OF Z1-ROAD
175
READ XM, YM, XN, YN OF Z2-ROAD
176
CALCULATE XZ, YZ WHERE ROADS CROSS
177
CALCULATE RD: DISTANCE FROM XA,YA TO XZ,YZ
178
CALCULATE RT: TIME PROPORT. TO RD
179
CALCULATE RA: ANGLE OF REF. LINE WITH X-AXIS
180
B


Fig.16

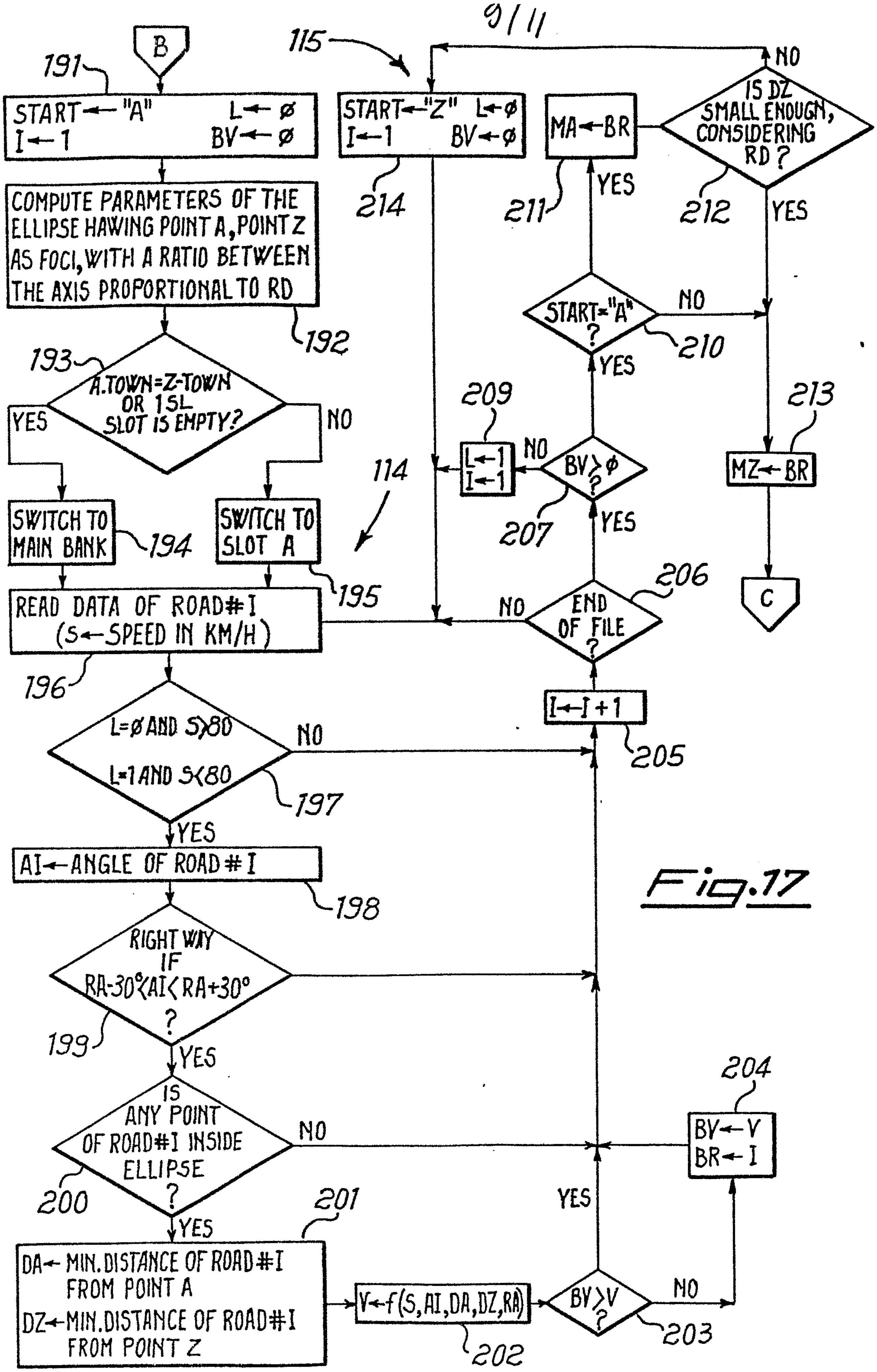
B
191
START ← "A" L ← ø
I ← 1 BV ← ø
COMPUTE PARAMETERS OF THE ELLIPSE HAWING POINT A, POINT Z AS FOCI, WITH A RATIO BETWEEN THE AXIS PROPORTIONAL TO RD
192
193
A.TOWN = Z-TOWN OR 1SL SLOT IS EMPTY?
YES
NO
SWITCH TO MAIN BANK
194
SWITCH TO SLOT A
195
READ DATA OF ROAD #I (S ← SPEED IN KM/H)
196
L=ø AND S>80
L=1 AND S<80
197
NO
YES
AI ← ANGLE OF ROAD #I
198
RIGHT WAY IF RA-30°<AI< RA+30° ?
199
YES
IS ANY POINT OF ROAD #I INSIDE ELLIPSE ?
200
NO
YES
DA ← MIN. DISTANCE OF ROAD #I FROM POINT A
DZ ← MIN. DISTANCE OF ROAD #I FROM POINT Z
201
V ← f(S, AI, DA, DZ, RA)
202
BV > V ?
203
NO
YES
BV ← V
BR ← I
204
I ← I + 1
205
END OF FILE ?
206
NO
YES
BV > ø ?
207
NO
L ← 1
I ← 1
209
YES
START = "A" ?
210
NO
YES
MA ← BR
211
IS DZ SMALL ENOUGH, CONSIDERING RD ?
212
NO
YES
MZ ← BR
213
C
115
START ← "Z" L ← ø
I ← 1 BV ← ø
214
114

Fig. 17

Fig. 18

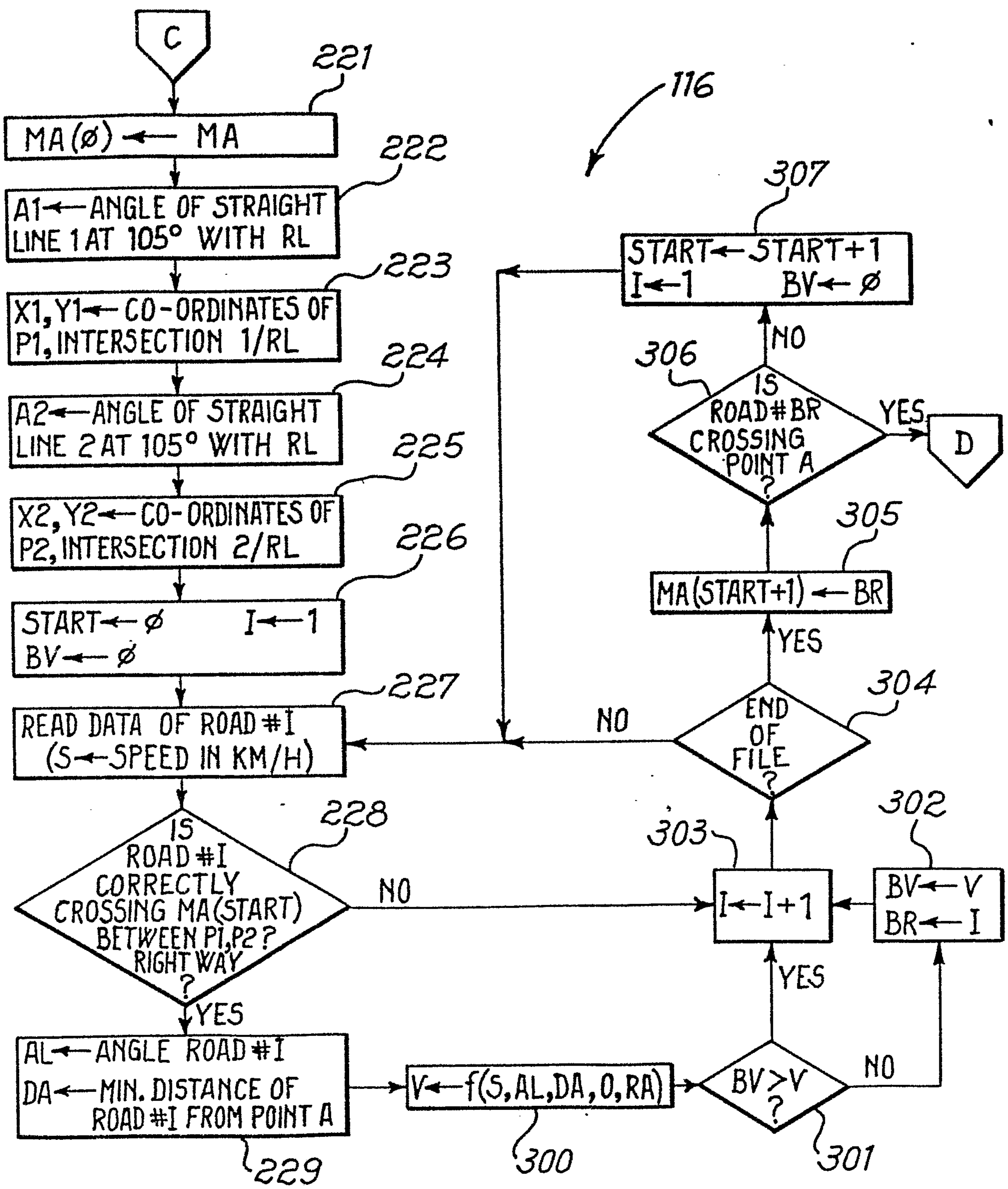
C
221
MA(Ø) ← MA
222
A1 ← ANGLE OF STRAIGHT LINE 1 AT 105° WITH RL
223
X1, Y1 ← CO-ORDINATES OF P1, INTERSECTION 1/RL
224
A2 ← ANGLE OF STRAIGHT LINE 2 AT 105° WITH RL
225
X2, Y2 ← CO-ORDINATES OF P2, INTERSECTION 2/RL
226
START ← Ø I ← 1
BV ← Ø
227
READ DATA OF ROAD #I (S ← SPEED IN KM/H)
228
IS ROAD #I CORRECTLY CROSSING MA(START) BETWEEN P1, P2? RIGHT WAY ?
YES
NO
AL ← ANGLE ROAD #I
DA ← MIN. DISTANCE OF ROAD #I FROM POINT A
229
V ← f(S, AL, DA, O, RA)
300
BV > V ?
301
YES
NO
I ← I+1
303
BV ← V
BR ← I
302
END OF FILE ?
304
NO
YES
MA(START+1) ← BR
305
IS ROAD # BR CROSSING POINT A ?
306
YES
D
NO
START ← START+1
I ← 1 BV ← Ø
307
116

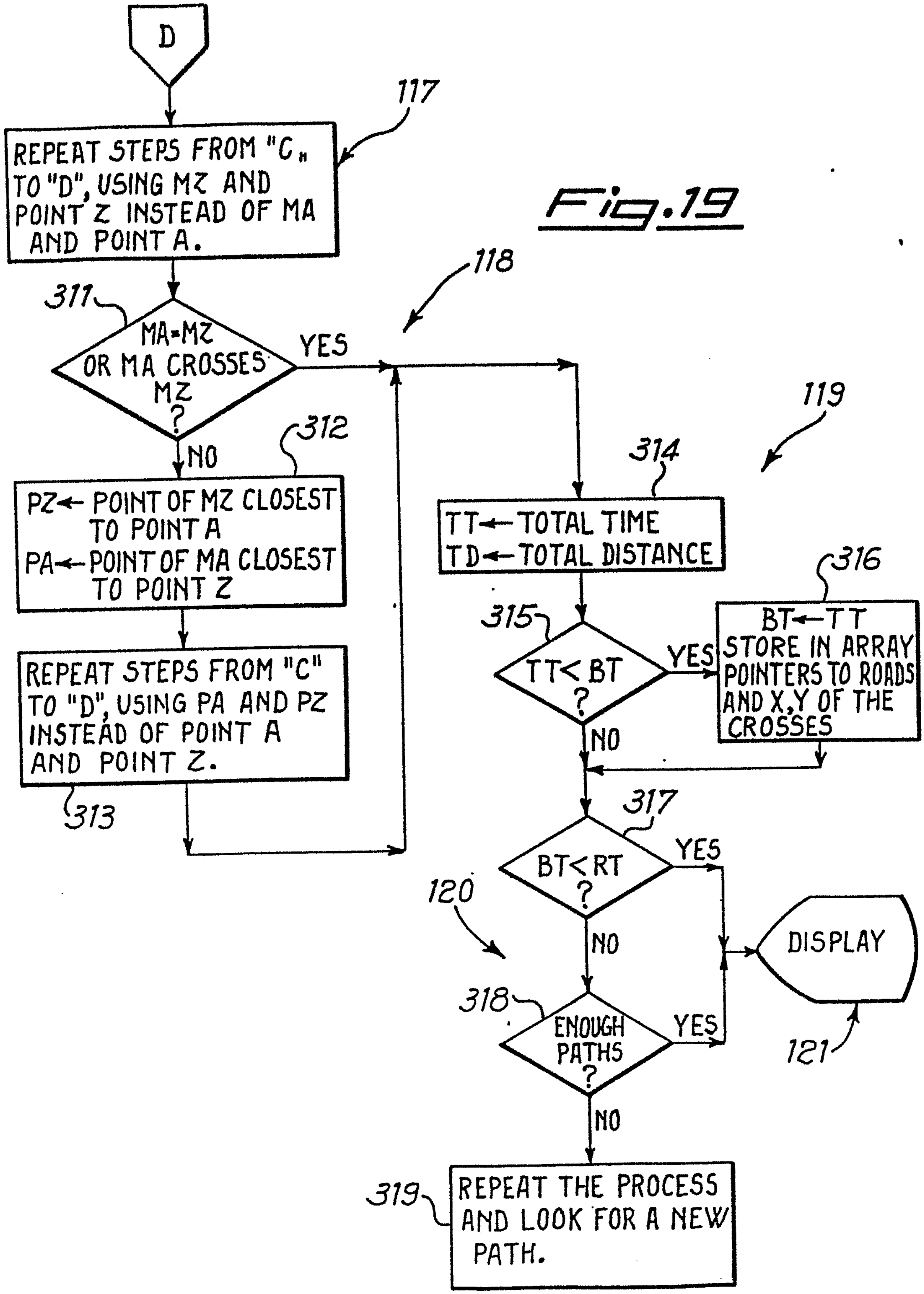
D
117
REPEAT STEPS FROM "C" TO "D", USING MZ AND POINT Z INSTEAD OF MA AND POINT A.
311
MA=MZ OR MA CROSSES MZ ?
YES
NO
118
312
PZ← POINT OF MZ CLOSEST TO POINT A
PA← POINT OF MA CLOSEST TO POINT Z
REPEAT STEPS FROM "C" TO "D", USING PA AND PZ INSTEAD OF POINT A AND POINT Z.
313
119
314
TT←TOTAL TIME
TD←TOTAL DISTANCE
315
TT<BT ?
YES
NO
316
BT←TT
STORE IN ARRAY POINTERS TO ROADS AND X,Y OF THE CROSSES
317
BT<RT ?
YES
NO
120
DISPLAY
121
318
ENOUGH PATHS ?
YES
NO
319
REPEAT THE PROCESS AND LOOK FOR A NEW PATH.

Fig.19